# EUROPEAN PATENT APPLICATION

(11) **EP 1 610 599 A1**
(43) Date of publication of application: **28.12.2005**
(21) Application number: 04723746.6
(22) Date of filing: 26.03.2004
(51) Int. Cl.: H05K 3/46

(54) **MULTILAYER SUBSTRATE AND METHOD FOR PRODUCING SAME**

(30) Priority: 28.03.2003 JP 2003090235; 31.03.2003 JP 2003093352; 31.03.2003 JP 2003095573
(71) Applicant: TDK Corporation, Tokyo 103-8272 (JP)
(72) Inventor: TAKAYA, Minoru, Chuo-ku, Tokyo 103-8272 (JP); ENDO, Toshikazu, Chuo-ku, Tokyo 103-8272 (JP); KOBUKE, Hisashi, Chuo-ku, Tokyo 103-8272 (JP); SASAKI, Masami, Chuo-ku, Tokyo 103-8272 (JP); KAJINO, Takashi, Chuo-ku, Tokyo 103-8272 (JP); GOTO, Katsuyoshi, Chuo-ku, Tokyo 103-8272 (JP)
(74) Representative: Grünecker, Kinkeldey, Stockmair & Schwanhäusser Anwaltssozietät
(86) International application number: PCT/JP2004/004277
(87) International publication number: WO 2004/089049

(57) **Abstract**

In a multilayered substrate obtained by laminating a plurality of substrates and including plural kinds of functional elements therein, a first functional material film and a second functional material film are provided on the same plane and first and second functional elements are formed by the first and second functional material films, respectively. The functional material film may be formed on a transferring substrate by a thin film method and may be transferred to the substrate.

## Description

### Technical Field

The present invention relates to a multilayered substrate and an electronic component using the same, and a method of manufacturing them, and more particularly to the structure and manufacturing method of a multilayered substrate provided with a functional element such as a capacitor or an inductor in an organic resin substrate.

### Background Art

With the development of a reduction in the size and thickness of an electronic apparatus such as a cell phone or a notebook computer, and an increase in a function and an enhancement in a performance, recently, a reduction in a size and thickness and an enhancement in a performance of a substrate to be used for them have been demanded greatly. For this reason, there has been proposed various substrate structures in which the substrate can be multilayered and a functional element such as a capacitor, an inductor or a resistor can be provided therein to carry out high density mounting.

An organic multilayered substrate is constituted by generally dispersing a functional material such as a dielectric ceramic powder or a magnetic powder into a resin substrate containing a glass cloth, while providing an electrode and a coil which are formed by a thin metal film and laminating substrates on each other with an insulating layer provided therebetween. As a method of providing a thin film material in a substrate, moreover, a thin film is directly formed on an organic substrate by sputtering and is laminated. For utilizing a thick film method, furthermore, there has been known an engineering method using a metallic foil having a resin, for example. JP-A-2002-271038 Publication has described a substrate structure of this type in which a functional element layer is provided in a substrate.

According to a composite substrate in which ceramics materials are mixed and dispersed into an organic resin material, an electric characteristic can be enhanced to some extent as compared with a resin substrate but the original electrical characteristic of the ceramics material is decreased considerably. For this reason, a high dielectric constant and a Q value cannot be obtained. For example, it is hard to fetch a capacitor element having a high capacity into a substrate with a conventional substrate structure. In an electronic component module in the existing circumstances, accordingly, it is necessary to employ a configuration in which a large number of surface mounting components such as a capacitor of a surface mounting type are mounted on the surface of the substrate:

Moreover, there is a problem in that a ceramic dielectric film formed by a thin film method generally has a poor crystallinity and the original electrical characteristic of a material cannot be exhibited sufficiently. For this reason, it is necessary to heat a substrate (to approximately 500 to 600 °C or more) in order to form a thin film having an excellent crystallinity and a good electrical characteristic. However, an ordinary resin substrate has a heating limit of approximately 200°C and heating is limited to at most approximately 400°C even if polyimide having a high heat resistance is used. With a substrate structure in which a thin film is directly formed on an organic substrate as described above, it is hard to form a ceramic dielectric thin film having an excellent electrical characteristic in respect of a heat resistance.

In the case in which the surface of the organic resin substrate is generally provided with a concavo-convex portion in order of several µm and has a poor smoothing property and a thin film having a thickness of approximately several tens nm is formed on the surface (a concavo-convex portion which is several hundred times as great as the thickness of a film is present on the surface of the resin substrate), furthermore, there is also a problem in that a defect is easily generated.

On the other hand, the invention described in the JP-A-2002-271038 has disclosed a composite multilayered substrate comprising different material regions on the same layer in order to reduce the size and thickness of a multilayered substrate including a functional element. For the substrate, however, it is necessary to laminate sheets constituted by different materials to form a block and to then slice the block in an orthogonal direction to the direction of extension of each sheet to form a composite material layer, and furthermore, to laminate the composite material layer. For this reason, a manufacturing process becomes complicated, and furthermore, an adhesive layer is to be always provided between the material regions. In respect of a mounting density, therefore, a sufficient structure has not been obtained yet.

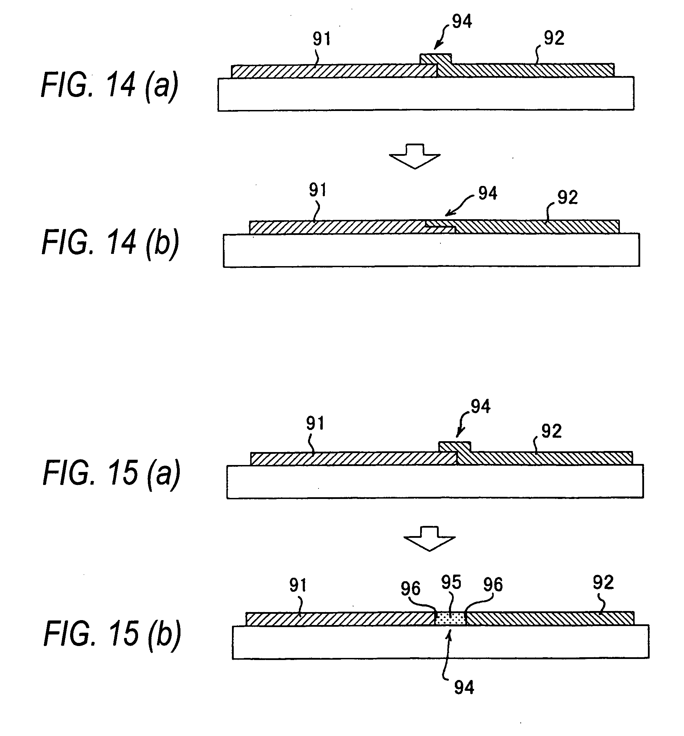

On the other hand, it can also be supposed that a plurality of different functional material films (for example, a dielectric film and a magnetic film) is simply formed in the same layer surface in the substrate in order to increase the mounting density of the inside of a substrate. As shown in Fig. 15, when different types of material films 91 and 92 are to be formed on a ceramic burning substrate, materials come in contact with each other during substrate burning or a reaction layer 95 is formed in a superposed portion 94 so that it is hard to obtain a desirable electrical characteristic in both of the material films 91 and 92. Moreover, there is also caused a problem in that a crack or breakage 96 is easily generated between both of the material films due to a difference between the thermal shrinkage ratios of the both of the materials 91 and 92. On the other hand, in some cases in which both of the functional material films are to formed by an organic material (a resin), the bonding strength of the contact portion of both of the material films is small and a clearance is generated between both of the films to deteriorate the reliability of the substrate.

### Disclosure of the Invention

Therefore, it is an object of the invention to obtain an organic multilayered substrate which can include a functional element having an excellent electrical characteristic at a high density and has a high reliability, and a manufacturing method thereof.

In order to achieve the object and to solve the problems, a multilayered substrate according to the invention is obtained by laminating a plurality of substrates and comprises plural kinds of functional elements therein, wherein plural kinds of functional material films including at least a first functional material film and a second functional material film formed by a second functional material which is different from the first functional material film are provided on the same plane of at least one of the substrates, and plural kinds of functional elements are formed by the plural kinds of functional material films.

A method of manufacturing a multilayered structure according to the invention in which a multilayered substrate including plural kinds of functional elements is manufactured in the substrate, comprises the step of providing, in the same plane of a core substrate, plural kinds of functional films including at least a first functional film and a second functional film which is different from the first functional film.

Desirable different functional material films can be provided in the same plane of the substrate constituting the multilayered substrate and plural kinds of different functional elements can be formed in the same plane in the multilayered substrate by the functional material films. Consequently, the mounting density of the substrate can be increased. More specifically, a material having a low dielectric constant and a material having a high dielectric constant are provided in the same plane of a core substrate, for example, and an inductor is formed in a region portion provided with a material having a low dielectric constant, while a capacitor is formed in a region portion provided with a material having a high dielectric constant. Moreover, it is possible to properly provide an optional material such as a dielectric material, a magnetic material, a piezoelectric material, a pyroelectric material or a semiconductor material in the same plane in the substrate, thereby including a desirable functional element in a multilayered substrate, for example. As the functional element, it is possible to form a capacitor, an inductor, a resistor, a varistor or another element, for example.

As a specific method of providing a functional material film on a substrate, it is possible to apply both a thin film method (for example, sputtering, evaporation, CVD, laser abrasion or the burning of a sol/gel forming film) and a thick film method (for example, a thin film of a functional material is formed and transferred by a printing method and a doctor blade method). According to the thin film method, a functional element having an excellent electrical characteristic and a high performance can be formed in the substrate. On the other hand, according to the thick film method which does not use a vacuum technique, it is possible to manufacture a multilayered substrate according to the invention at a low cost in a simple process.

In the multilayered substrate according to the invention, furthermore, at least one capacitor element layer is provided in the substrate, and the capacitor element layer is formed by a dielectric ceramic layer provided by a thin film method and having a crystallinity enhanced by a heat treatment and an electrode film disposed on both surfaces of the dielectric ceramic layer, and is held by a substrate mainly containing a resin.

In such a multilayered substrate according to the invention, the dielectric ceramic layer formed by the thin film method is heat treated to enhance the crystallinity and to increase the dielectric constant, and is then held by the substrate mainly containing the resin and is laminated to form the multilayered substrate. Consequently, a ceramic layer having a high dielectric constant can be formed in the substrate and a capacitor having a high capacity can be provided in an organic multilayered resin substrate. In order to heat treat the dielectric ceramic layer, specifically, the dielectric ceramic layer is formed on a transferring substrate having a heat resistance and is heat treated, and is then transferred to an organic resin substrate as in a manufacturing method which will be described below, for example.

### Brief Description of the Drawings

Fig. 1 is a horizontal sectional view showing a multilayered substrate (a layer in which different kinds of material layers are formed) according to a first embodiment of the invention.
Fig. 2 is a vertical sectional view showing the multilayered substrate according to the first embodiment.
Figs. 3(a) to 3(o) are sectional views sequentially showing a process for manufacturing the multilayered substrate according to the first embodiment.
Fig. 4 is a vertical sectional view showing a multilayered substrate according to a second embodiment of the invention.
Fig. 5 is a vertical sectional view showing the exploded multilayered substrate according to the second embodiment.
Figs. 6(a) to 6(o) are sectional views sequentially showing a process for manufacturing the multilayered substrate according to the second embodiment.
Fig. 7 is a horizontal sectional view showing a multilayered substrate (a layer in which different kinds of material films are formed) according to a third embodiment of the invention.
Fig. 8 is a vertical sectional view showing the multilayered substrate according to the third embodiment.
Fig. 9 is a horizontal sectional view showing a multilayered substrate (a layer in which different kinds of material films are formed) according to a fourth embodiment of the invention.
Fig. 10 is a vertical sectional view showing the multilayered substrate according to the fourth embodiment.
Fig. 11 is a horizontal sectional view showing a multilayered substrate (a first layer in which different kinds of material films are formed) according to a fifth embodiment of the invention.
Fig. 12 is a horizontal sectional view showing a multilayered substrate (a second layer in which different kinds of material films are formed) according to the fifth embodiment.
Fig. 13 is a vertical sectional view showing the multilayered substrate according to the fifth embodiment,
Figs. 14(a) and 14(b) are sectional views showing a layer in which different kinds of material films are formed according to the invention.
Figs. 15(a) and 15(b) are sectional views showing the layer in which the different kinds of material films are formed in the case in which the different kinds of material films are to be formed on the same layer in a ceramic burning substrate. Fig. 15(a) shows a state brought before burning and Fig. 15(b) shows a state brought after the burning.
Figs. 16(a) to 16(k) are sectional views sequentially showing a manufacturing process in a method of manufacturing a multilayered substrate according to a sixth embodiment of the invention.
Fig. 17 is a sectional view showing an example of a multilayered substrate according to the invention.
Figs. 18(a) to 18(n) are sectional views sequentially showing a process for manufacturing a multilayered substrate according to an example of the invention.
Fig. 19(a) is a plan view showing an example of the structure of a dielectric ceramic layer according to the invention and Fig. 19(b) is a sectional view.
Fig. 20(a) is a plan view showing another example of the structure of the dielectric ceramic layer according to the invention and Fig. 20(b) is a sectional view.
Fig. 21 is an X-ray diffraction chart showing a state brought immediately after sputtering for a BaTiO₃ thin film formed by the sputtering (in the case in which a heat treatment is not carried out).
Fig. 22 is an X-ray diffraction chart showing the case in which the BaTiO₃ thin film formed by the sputtering is heat treated at 300°C.
Fig. 23 is an X-ray diffraction chart showing the case in which the BaTiO₃ thin film formed by the sputtering is heat treated at 500°C.
Fig. 24 is an X-ray diffraction chart showing the case in which the BaTiO₃ thin film formed by the sputtering is heat treated at 700°C.
Fig. 25 is an X-ray diffraction chart showing a BaTiO₃ sintered product.

### Best Mode for Carrying Out the Invention

Embodiments of the invention will be described below with reference to the accompanying drawings.

### [First Embodiment]

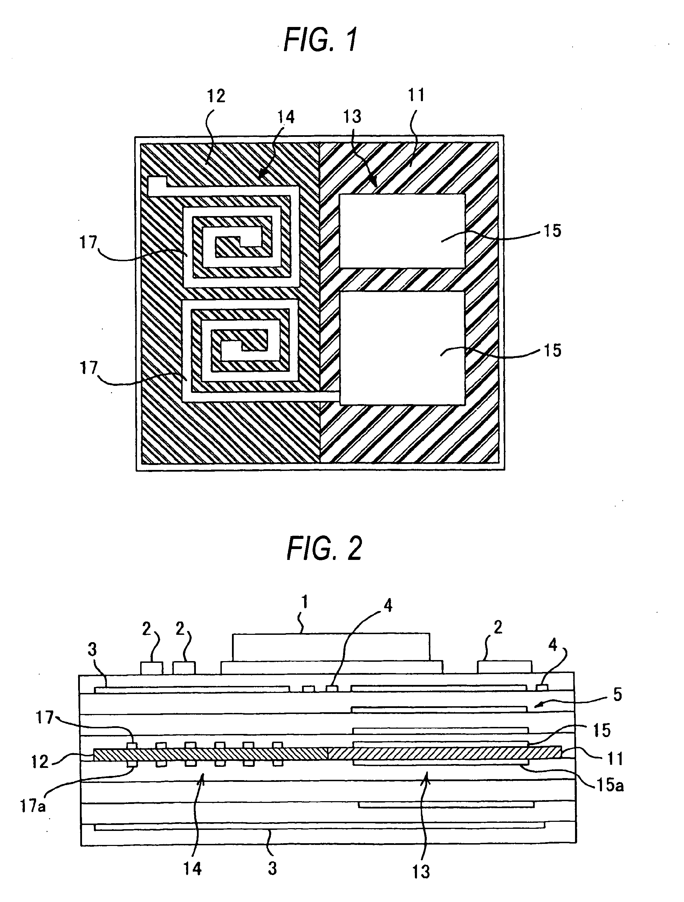

Figs. 1 and 2 show a multilayered substrate according to an embodiment of the invention. As shown in Figs. 1 and 2, the multilayered substrate has such a structure that thin films 11 and 12 formed by different materials are provided in the same plane on the inside of the substrate, and different kinds of functional elements, a capacitor 13 having a high capacity and an inductor 14 are provided on the same layer in the substrate by the thin films.

More specifically, in the embodiment, the high dielectric material thin film 11 is formed as a first functional material film by a material having a high dielectric constant and the low dielectric material thin film 12 is formed as a second functional material film by a material having a low dielectric constant. Electric conductors 15 and 15a patterned rectangularly are provided on both surfaces of the high dielectric material thin film 11 to form the capacitor 13 having a high capacity (the first functional element), while electric conductors 17 and 17a patterned to have a spiral shape are provided on both surfaces of the low dielectric material thin film 12 to form the inductor 14 (the second functional element).

Each of the high and low dielectric material films 11 and 12 is set to be a thin film formed by using a thin film method such as sputtering, evaporation, CVD, laser abrasion and the burning of a sol/gel forming film and is set to have a thickness of 5µm or less. In the case in which the film is formed by a resin or a composite material obtained by mixing and dispersing a ceramic material into the resin, a dielectric constant is approximately 1 to 50 and a dielectric tangent (tanδ) is approximately 0.002 to 0.02. On the other hand, according to the thin film in accordance with the embodiment, it is possible to obtain a dielectric constant of approximately 3 to 1000 and a tanδ value of approximately 0.001 to 0.1.

Examples of a specific material which can be used for forming the dielectric material thin films 11 and 12 include barium titanate type ceramics, titanium - barium - neodymium type ceramics, titanium - barium - tin type ceramics, lead - calcium type ceramics, titanium dioxide ceramics, lead titanate type ceramics, strontium titanate type ceramics, calcium titanate type ceramics, bismuth titanate type ceramics, magnesium titanate type ceramics, CaWO₄ type ceramics, Ba (Mg, Nb) O₃ type ceramics, Ba (Mg, Ta) O₃ type ceramics, Ba (Co, Mg, Nb) O₃ type ceramics, and Ba (Co, Mg, Ta) O₃ type ceramics.

As the functional material film to be formed in the same plane, it is possible to provide various material films such as films constituted by a magnetic material (for example, Fe-Ni-Zn type ceramics, Mn-Zn type ferrite, Ni-Zn type ferrite, Mn-Mg-Zn type ferrite, Ba type ferrite, Sr type ferrite, Ni-Cu-Zn type ferrite, iron oxide such as Fe₂O₃ or Fe₃O₄, Fe or various magnetic alloys containing Fe), a piezoelectric material (for example, PbTiO₃ - PbZrO₃), a pyroelectric material (for example, PbTiO₃) and a semiconductor material (for example, BaTiO₃) in addition to the dielectric material film as described above, and various functional elements such as a capacitor, an inductor, a resistor and a varistor can be constituted by them.

It is possible to provide a capacitor 5, a ground electrode 3, other functional elements and various wirings 4 for the other layers of the substrate. Moreover, it is possible to properly form a through hole or a via hole (not shown) in order to carry out an electrical connection between layers provided with these elements. A surface mounting component such as an IC1 or various chip components 2 can be mounted on the surface of the substrate. Consequently, it is possible to form a desirable electronic component module.

For example, it is possible to constitute various electronic components such as a coil, a capacitor, an antenna, a BPF, an LPF, an HPF, a diplexer, a duplexer, a coupler, a balun, a delay line, an antenna switch module, a front end module, a power amplifier, a VCO, a PLL module, a mixer module, an IF module, an isolator, a DC-DC converter or a tuner unit in accordance with the invention.

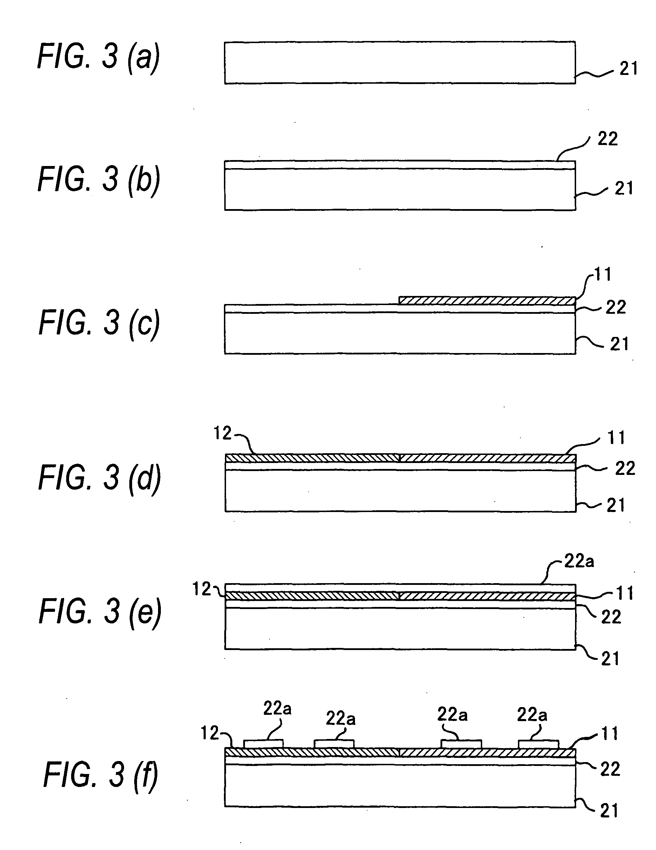

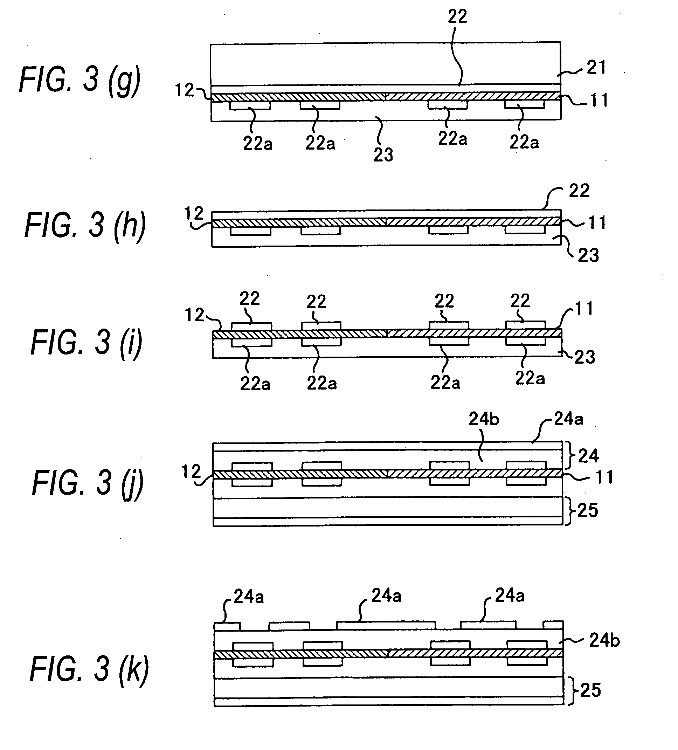

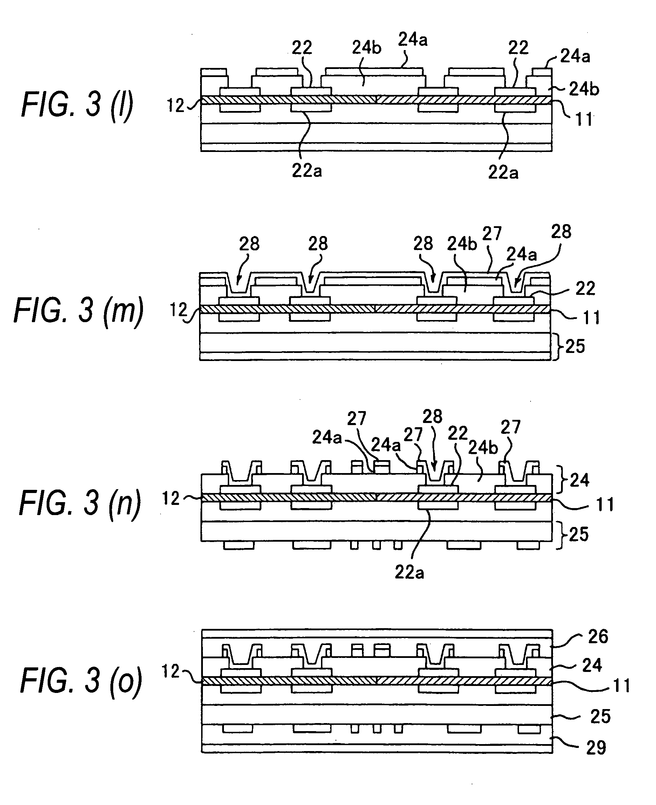

Figs. 3 (a) to 3(o) sequentially show a process for manufacturing a multilayered substrate according to the first embodiment. Based on these drawings, description will be given to the process for manufacturing a multilayered substrate according to the embodiment.
(1) First of all, a transferring substrate 21 is prepared (Fig. 3(a)), and a metal film 22 to be the electrode of a capacitor and an inductor is formed on the surface of the transferring substrate 21 by a thin film method (Fig. 3(b)). An SUS (stainless) substrate having a thickness of 0.1 mm is used as the transferring substrate 21, for example, and copper (Cu) and nickel (Ni) are laminated on the surface of the substrate by sputtering in this order to have a thickness of 0.1µm respectively, thereby forming the metal film 22.
   For the transferring substrate 21, for example, it is possible to use a substrate such as silicon, alumina, zirconia, quartz, sapphire, magnesium oxide or zirconium oxide in addition to the SUS substrate. It is desirable to use a substrate formed by an inorganic substrate having a heat resistance of 500°C or more.
   On the other hand, for the metal film 22, it is possible to use titanium (Ti), gold, (Au), silver (Ag), platinum (Pt), palladium (Pd), tungsten (W) or molybdenum (Mo), for example, or an alloy including at least one of them in addition to copper and nickel, and to utilize various electric conductor materials having a conductivity.
   As a method of forming the metal film 22, it is possible to use evaporation, CVD, laser abrasion, the burning of a sol/gel film, plating and other methods described above in addition to sputtering. In order to enhance the reliability of the substrate, it is desirable to employ a dry method such as sputtering, evaporation or CVD which can form a smoother metal film. According to these dry film forming methods, it is possible to prevent a concavo-convex portion such as an electrolytic metallic foil from being generated, particularly, to prevent the generation of a local electric field concentration to enhance the reliability of the substrate when forming the counter electrode of a capacitor.
(2) Next, the high dielectric material thin film 11 is formed as the first functional material film in a region in which a capacitor is to be formed on the metal film 22 (Fig. 3(c)). The formation of the high dielectric material thin film 11 is carried out through a thin film method such as sputtering by providing a mask for covering the surface of a metal film other than the region in which the capacitor is to be formed. For example, a thin film of barium titanate can be formed on the metal film 22 in a thickness of 0.3µm by RF sputtering on a heating condition of 600°C so that the high dielectric material thin film 11 can be obtained.
   After the formation of the thin film 11, moreover, it is also possible to carry out a heat treatment over the thin film 11 to enhance a crystallinity. It is preferable that the temperature of the heat treatment should be set to be equal to or higher than 400°C (for example, 500°C to 900°C). Consequently, it is possible to form a dielectric layer having a stable crystal structure and an excellent dielectric characteristic. Although it is desirable that a crystalline form should have a single crystal structure from which a more excellent dielectric characteristic can be obtained, a polycrystalline structure may be employed. The functional material film according to the invention is not always restricted to a film having a crystal structure but also includes a film set in an amorphous state.
(3) Subsequently, the low dielectric material thin film 12 is formed as the second functional material film in a region in which an inductor is to be formed on the metal film 22 (Fig. 3(d)). The formation of the low dielectric material thin film 12 is carried out through a thin film such as sputtering by providing a mask for covering the surface of a metal film other than the region in which the inductor is to be formed. For example, a thin film of Al₂O₃ (alumina) can be formed in a thickness of 0.3µm on the metal film 22 by the sputtering on a heating condition of 600°C and can be set to be the low dielectric material thin film 12. Prior to the formation of the low dielectric material thin film, for example, SiO₂ may be formed on the metal film 12 in a thickness of 0.2µm by the sputtering and the low dielectric material thin film 12 may be formed thereon in order to maintain an insulating property.
(4) After the formation of each of the high and low dielectric material thin films 11 and 12, a metal film 22a for forming a capacitor electrode and an inductor is provided on the thin films 11 and 12 by the thin film method such as the sputtering (Fig. 3(e)).
(5) Then, the metal film 22a is patterned by etching (Fig. 3(f)) to form a rectangular pattern to be the capacitor electrode and a spiral pattern to be the inductor. Both wet etching and dry etching can be applied to the patterning.
(6) After the patterning, the transferring substrate 21 is inverted and a press processing is carried out to perform a transfer while a prepreg (an organic resin substrate in a B stage state) 23 is pressurized and heated (Fig. 3(g)). After the prepreg 23 is cured, the transferring substrate 21 is peeled (Fig. 3(h)). In place of the use of the prepreg, it is also possible to press resin substrates in a curing state with another adhesive film interposed therebetween, thereby carrying out a transfer.
   It is preferable that the organic resin substrate (prepreg) to be transferred should have a low water absorbing property in order to enhance the reliability of the substrate. More specifically, it is possible to utilize both a thermoplastic resin and a thermosetting resin and to use an epoxy resin, a phenol resin, a vinylbenzyl ether compound, bismaleimide triazine, a polyolefin type resin, polyimide, polyester, polyphenylene oxide, polyphenylene sulfide, a liquid crystal polymer, a fluorine type resin, for example, and a resin containing at least one of them.
(7) After the transferring substrate 21 is peeled, patterning is carried out over the metal film 22 which is first formed and covers the surfaces of the high dielectric material thin film 11 and the low dielectric material thin film 12. More specifically, a counter electrode of a capacitor and an inductor are formed respectively (Fig. 3(i)) in alignment with the capacitor electrode and the inductor (metal film 22a) which are formed by the patterning (Fig. 3(f)).
(8) After the metal film 22 is patterned, metallic foils 24 and 25 having resins are pressed and stuck to both surfaces of the substrate (Fig. 3(j)).
(9) Then, a copper foil 24a on a surface layer is etched to form a hole for creating a laser via (Fig. 3(k)), and a laser beam is irradiated thereon to form a hole in a resin portion 24b of the metallic foil 24 having a resin (Fig. 3(1)), and electroless plating and electrolytic plating are carried out to provide a metal film 27 and a via hole 28 is thus formed (Fig. 3(m)).
(10) After the via hole 28 is formed, the metallic foils 24 and 25 having resins on both surfaces are patterned by etching (Fig. 3(n)), and then, metallic foils 26 and 29 having resins are further pressed and stuck to both surfaces (Fig. 3(o)).

Subsequently, it is possible to form the multilayered substrate according to the embodiment shown in Fig. 2 by repeating the steps (8) to (10) (Figs. 3(j) to 3(o)) which have generally been known as a build-up method.

Another substrate to be laminated at the laminating step (Fig. 3(j)) may contain a single film material on the same plane as shown in Fig. 3(j), and it is a matter of course that different kinds of materials can be provided on the same plane formed at the step of Fig. 3(i) and a plurality of substrates including the different kinds of material films can be laminated.

Referring to the functional film to be formed on the same plane, moreover, it is also possible to provide a material having a low dielectric constant and a material having a high dielectric constant to form an inductor and a capacitor on the same plane, for example, or to provide various materials such as a piezoelectric material (for example, PbTiO₃ - PbZrO₃), a pyroelectric material (for example, PbTiO₃) and a semiconductor material (for example, BaTiO₃) and to form various functional elements on the same layer surface by these materials. While two kinds of film forming materials are provided on the same plane in the embodiment, furthermore, it is also possible to form three kinds of materials (functional films) or more on different regions in the same plane in the same manner.

It is possible to mount surface mounting components such as an IC and various chip components on the surface of the multilayered substrate thus formed. Moreover, it is possible to properly form a through hole or a via hole (not shown) in order to carry out an electrical connection between layers in the same substrate.

### [Second Embodiment]

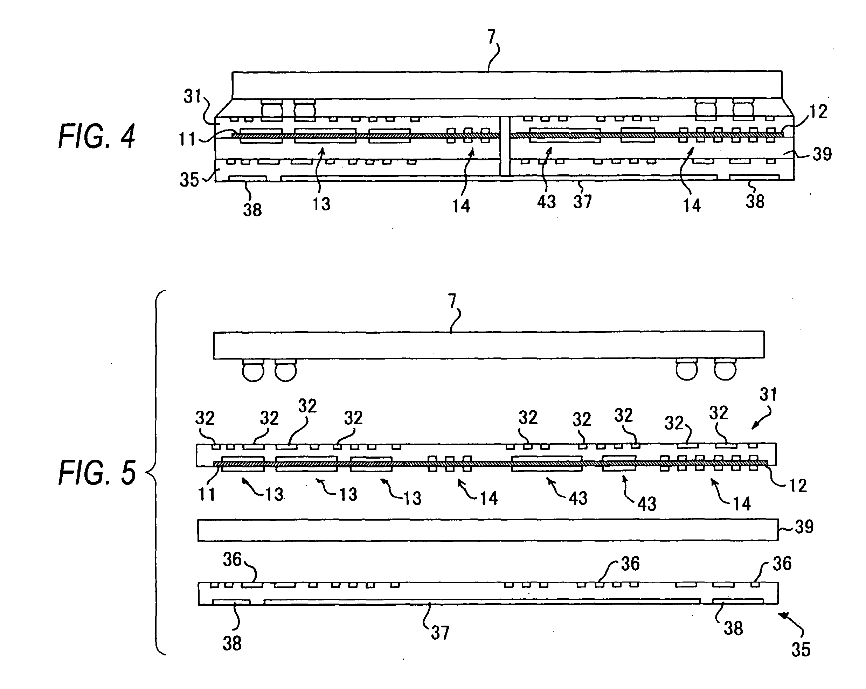

Figs. 4 and 5 show a multilayered substrate according to a second embodiment of the invention. As shown in these drawings, the multilayered substrate have four layers in which a core substrate 31 including different kinds of material films 11 and 12 on one surface and an electric conductor pattern 32 for bare chip mounting on the other surface and the other substrate 35 including a wiring pattern 36 on one surface and a ground pattern 37 and a land pattern 38 on the other surface are integrated with a prepreg 39 interposed therebetween, and a bare chip 7 can be flip chip mounted on the surface of the substrate.

The core substrate 31 having different kinds of material films has the high dielectric material thin film 11 (the first functional material film) and the low dielectric material thin film 12 (the second functional material film) formed on one of surfaces (a lower surface) thereof, and a capacitor 13 having a high capacity is formed in a high dielectric material thin film portion by the thin films 11 and 12, and furthermore, a capacitor 43 having a low capacity and an inductor 14 are formed in a low dielectric material thin film portion. In the embodiment, a reduction in a thickness is considered with first priority and the capacitor 43 having a low capacity (a low dielectric constant) is also formed by a thin film dielectric. Moreover, the electric conductor pattern 32 for bare mounting at a small pitch is formed on the other surface (upper surface) of the core substrate 31.

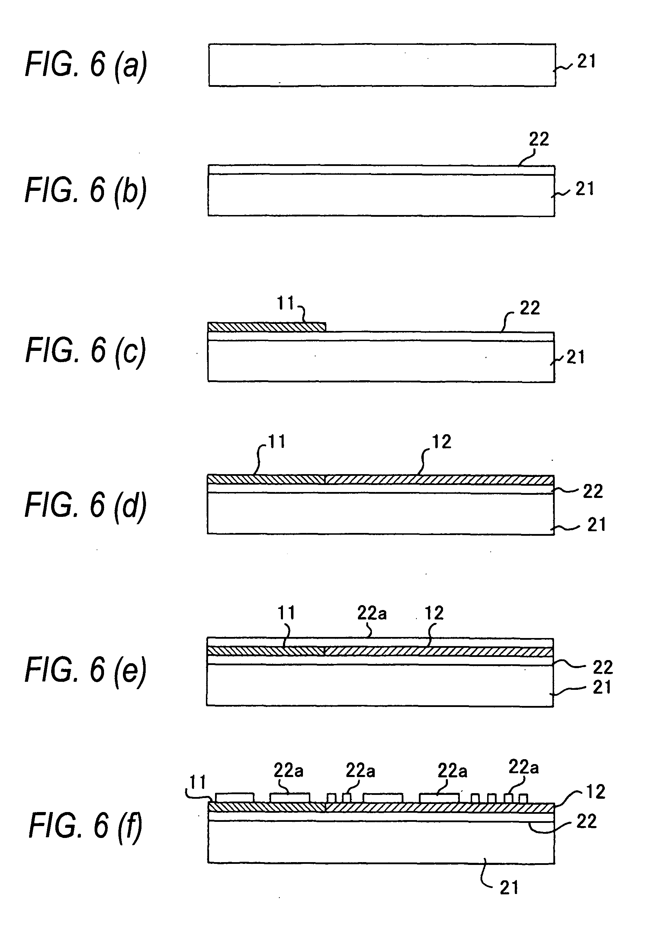

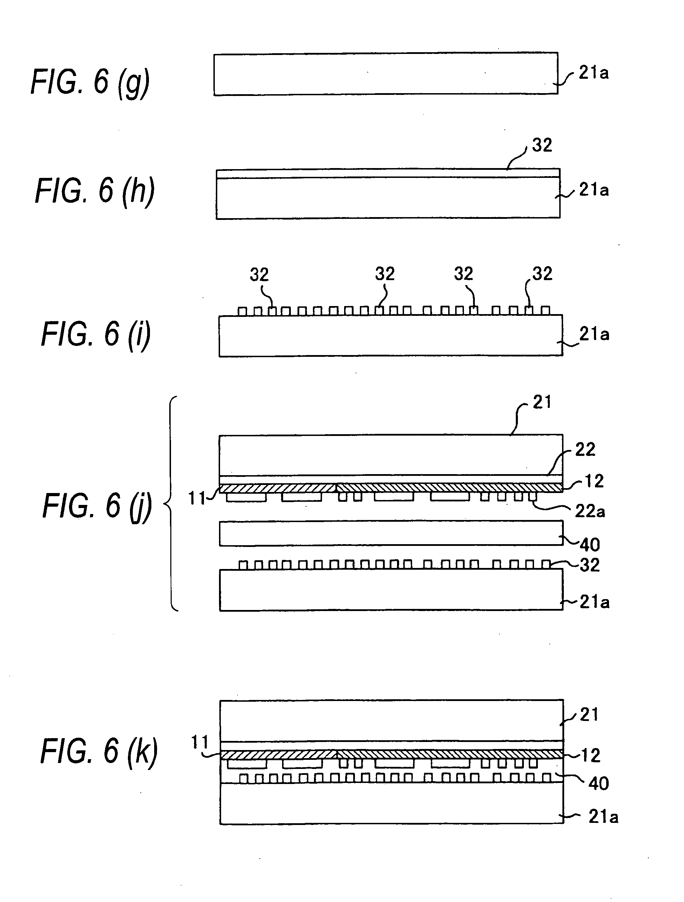

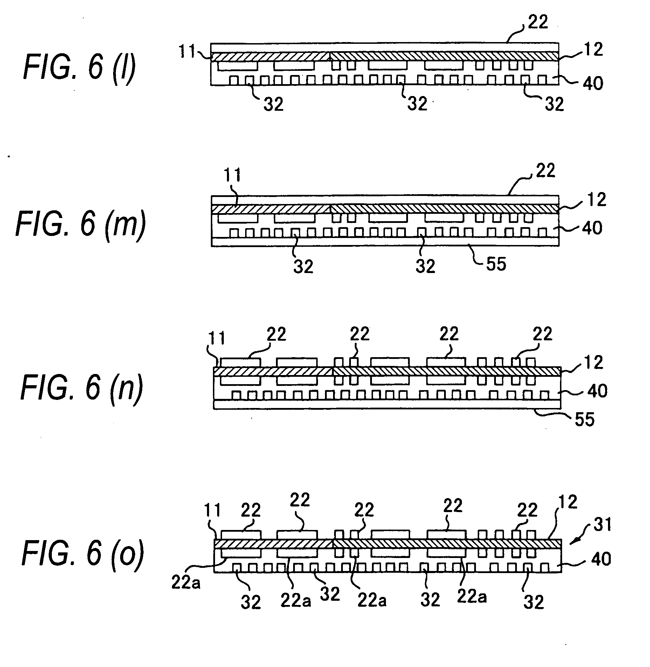

Based on Figs. 6(a) to 6(o), specific description will be given to a process for manufacturing a multilayered substrate according to the second embodiment.
(1) First of all, a transferring substrate 21 is prepared (Fig. 6(a)), and a metal film 22 to be a capacitor electrode or an inductor conductor is formed on the surface of the transferring substrate 21 by a thin film method (Fig. 6(b)). For the transferring substrate 21, a stainless substrate having a high heat resistance is used, for example, and films of copper (Cu) and titanium (Ti) are formed on the surface of the substrate by sputtering in this order. Referring to the types of the transferring substrate 21 and the metal film 22 and the thin film method which can be applied, it is possible to use various other types and methods in the same manner as described in the first embodiment.
(2) After the metal film 22 is formed, the high dielectric material thin film 11 is provided in a region on the film 11 in which a capacitor having a high capacity is to be formed (Fig. 6(c)). The formation of the film is carried out through a thin film method such as sputtering by covering, with a mask, the surface of a metal film other than the region in which the capacitor having a high capacity is to be formed. After the formation of the film, a heat treatment may be carried out in order to enhance the crystallinity of the thin film 11.
(3) Next, the low dielectric material thin film 12 is formed in a region on the metal film 22 in which an inductor and a capacitor having a low capacity are to be formed (Fig. 6(d)). The formation of the film is carried out through the thin film method such as the sputtering by covering, with a mask, the surface of the metal film other than the region in which the inductor and the capacitor having a low capacity are to be formed in the same manner as in the formation of the thin film 11.
(4) Then, a metal film 22a is formed on the thin films 11 and 12 by the thin film method such as the sputtering (Fig. 6(e)). The metal film 22a is formed by laminating Ti and Cu in this order.
(5) Thereafter, the metal film 22a is patterned by etching (Fig. 6(f)) to form a capacitor electrode and an inductor.
(6) On the other hand, in order to form a fine electric conductor pattern for bare chip mounting which is provided on the other surface (upper surface) of the core substrate 31, a transferring substrate 21a is separately prepared (Fig. 6(g)) and the metal film 32 is formed on the surface of the transferring substrate by the thin film method (Fig. 6(h)). For the transferring substrate 21 a, a stainless substrate having a high heat resistance, for example, and films of Cu and Ti are formed on the substrate surface 21 a in this order by the thin film method such as the sputtering.
(7) After the formation of the film, the metal film is patterned by etching (Fig. 6(i)) to form the electric conductor pattern 32 for bare chip mounting.
(8) Then, the transferring substrate 21a provided with the electric conductor pattern 32 for bare chip mounting and the transferring substrate 21 having the metal film 22a patterned (Fig. 6(f)) are provided in such a manner that pattern forming surfaces are opposed to each other, and a prepreg 40 is provided between the transferring substrates 21 and 21a (Fig. 6(j)) and the substrates 21 and 21 a are heated and pressed against each of the upper and lower surfaces of the prepreg 40 (Fig. 6(k)).
(9) After the prepreg 40 is cured, both of the transferring substrates 21 and 21a are peeled so that the different kinds of material thin films 11 and 12 including the electric conductors 22 and 22a and the electric conductor 32 for bare chip mounting are transferred to the prepreg 40 (Fig. 6(l)).
(10) After the transfer is completed, the electric conductor forming surface for bare chip mounting is coated with a resist 55 in order to protect the fine pattern 32 (Fig. 6(m)), and thereafter, patterning is carried out over the metal film 22 (Fig. 6(b)) which is first formed and covers the surfaces of the high and low dielectric material thin films 11 and 12. More specifically, a counter electrode of a capacitor and an inductor are formed (Fig. 6(n)) in alignment with the capacitor electrode and the inductor (the electric conductor 22a) which is formed by the patterning, respectively (Fig. 6(f)).
(11) After the patterning of the metal film 22, the resist 55 covering the fine pattern 32 is removed (Fig. 6(o)) so that the core substrate 31 is finished.
(12) Subsequently, the substrate 31 is set to be the core substrate to laminate the substrates. More specifically, the other substrate 35 including the wiring pattern 36, the ground pattern 37 and the land pattern 38 on a surface and a back face respectively is separately created (see Fig. 5), and the substrate 35 and the finished core substrate 31 are integrated with each other with the prepreg 39 interposed therebetween. Furthermore, the bare chip 7 is flip chip mounted on the fine pattern conductor 32 over the surface of the core substrate 31.

According to the embodiment in which a transfer process is used, it is possible to carry out patterning at a very small pitch. The reason is that a fully additive process can be applied by causing a transferring substrate to have a conductivity (for example, using a stainless substrate) according to the transfer process. Therefore, it is possible to carry out very fine patterning with high precision without the necessity of using electroless plating or soft etching.

In order to flip chip mount a large scale bare chip, patterning at a very small pitch is also required for the substrate side. The reason is that the large scale bare chip has a large number of terminals and the terminals are arranged at a small pitch. According to the multilayered substrate in accordance with the embodiment which includes the very fine conductor pattern, it is also possible to correspond to the mounting of such a large scale bare chip.

### [Third Embodiment]

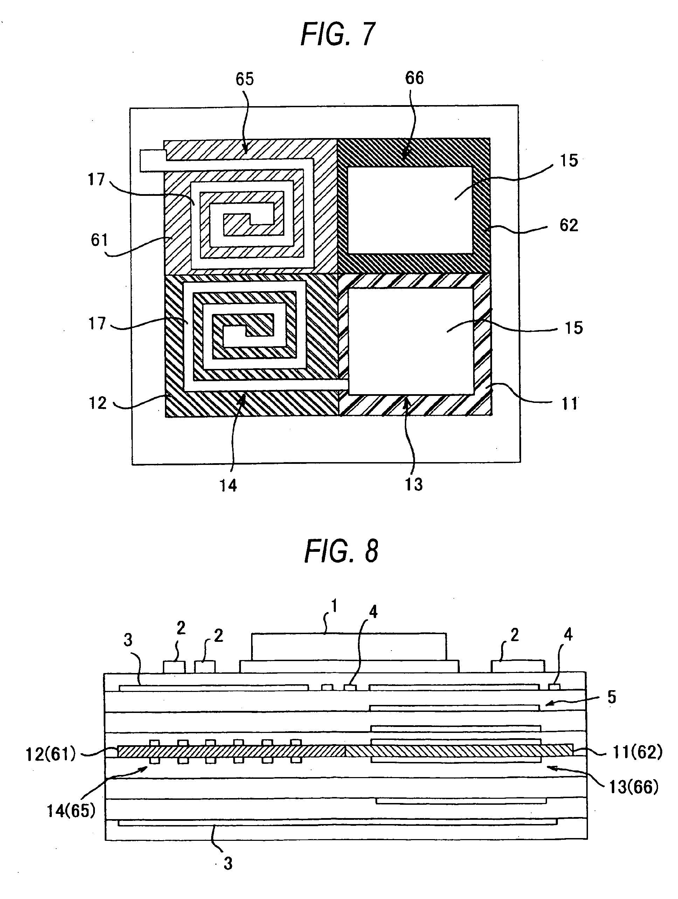

Figs. 7 and 8 show a multilayered substrate according to a third embodiment of the invention. While two different kinds of material films (the high dielectric material thin film and the low dielectric material thin film) are provided in the same layer in the substrate in the first and second embodiments, a thin film constituted by a magnetic material, a magnetic thin film 61 (a third functional material film), a thin film constituted by a ceramic semiconductor material, and a semiconductor thin film 62 (a fourth functional material film) are provided and four kinds of functional material films in total are formed on the same layer surface in addition to a high dielectric material thin film 11 (a first functional material film) and a low dielectric material thin film 12 (a second functional material film) as shown in Fig. 7 in the substrate according to the embodiment.

Then, an electric conductor 15 patterned rectangularly and an electric conductor 17 patterned spirally are provided adjacently to the high dielectric material thin film 11 and the low dielectric material thin film 12 so that a capacitor 13 (a first functional element) having a high capacity and an inductor 14 (a second functional element) are formed respectively in the same manner as in the embodiments described above. In the embodiment, furthermore, the electric conductor 17 patterned spirally is provided on both surfaces of the magnetic thin film 61 to form an impeder 65 (a third functional element), and furthermore, the electric conductor 15 patterned rectangularly is provided on both surfaces of the semiconductor thin film 62 to form a varistor 66 (a fourth functional element).

As a material for forming the magnetic thin film 61, it is possible to use the Fe-Ni-Zn type ceramics, the Mn-Zn type ferrite, the Ni-Zn type ferrite, the Mn-Mg-Zn type ferrite, the Ba type ferrite, the Sr type ferrite, the Ni-Cu-Zn type ferrite, the iron oxide such as Fe₂O₃ or Fe₃O₄, Fe or various magnetic alloys containing Fe, for example. Moreover, BaTiO₃ can be used as a material for forming the semiconductor thin film 62, for example.

In the invention, thus, it is possible to provide an optional number (for example, three, four or more) of different kinds of material films, thereby forming plural kinds (for example, three, four or more) of functional elements.

In the embodiment, a ground electrode 3, a wiring 4, a capacitor 5 and other functional elements can be formed on layers other than a layer on which different kinds of functional material films are provided, and furthermore, various surface mounting components 1 and 2 can be mounted on the surface of the substrate in the same manner as in the first embodiment. Since a specific method (process) for manufacturing a multilayered substrate according to each of the embodiment, and fourth and fifth embodiments which will be described below is the same as that for the multilayered substrate according to the first embodiment, moreover, description will be omitted.

### [Fourth Embodiment]

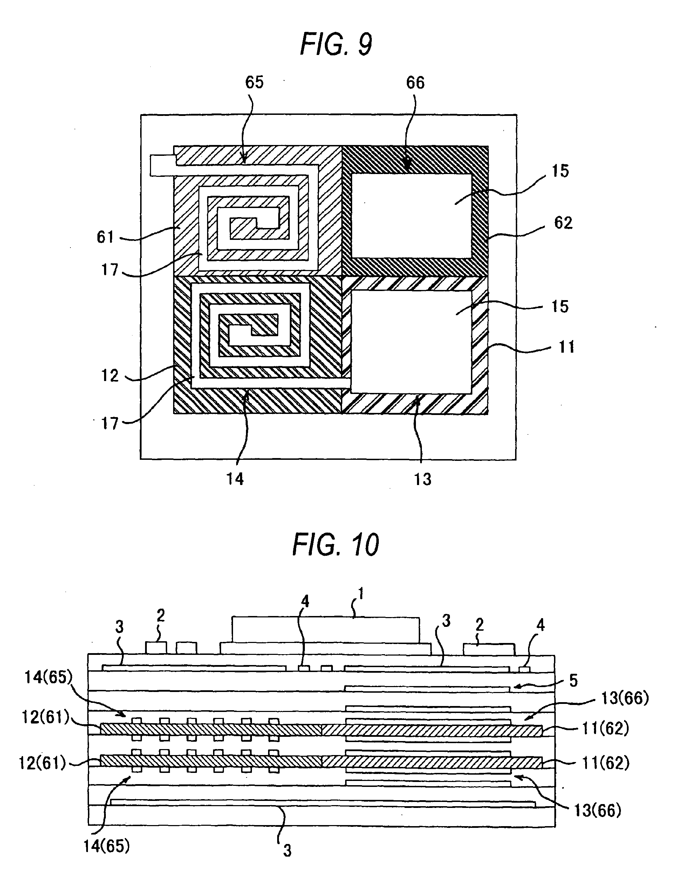

Figs. 9 and 10 show a multilayered substrate according to a fourth embodiment of the invention. As shown in Fig. 10, the multilayered substrate comprises a plurality of layers in which different kinds of material films are provided on the same plane. While one layer is provided with the different kinds of material films in the first to third embodiments, the number of layers on which different kinds of material films are to be formed may be two, three or more as in the embodiment.

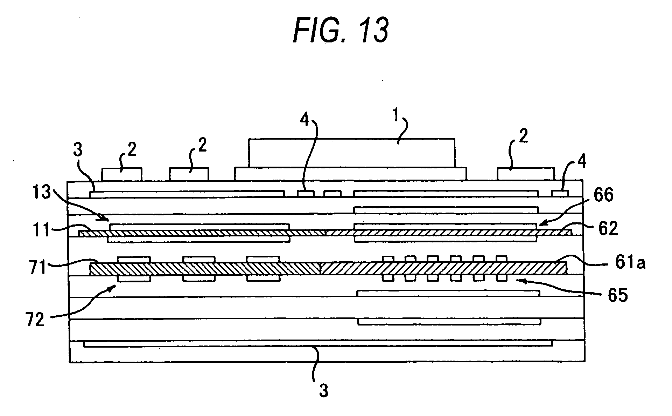

In the same manner as in the third embodiment, each of the layers on which different kinds of material films are to be formed has a high dielectric material thin film 11, a low dielectric material thin film 12, a magnetic thin film 61 and a semiconductor thin film 62, and comprises an electric conductor 15 patterned rectangularly for a capacitor electrode, an electric conductor 17 patterned spirally for an inductor, an electric conductor 17 patterned spirally for an impeder, and an electric conductor 15 patterned rectangularly for a varistor on both surfaces of each of the films, respectively. In Figs. 9 and 10 and Figs. 11 to 13 which will be described below, moreover, identical or corresponding portions to those in each of the embodiments (Figs. 1 to 8) have the same reference numerals and repetitive description will be omitted.

### [Fifth Embodiment]

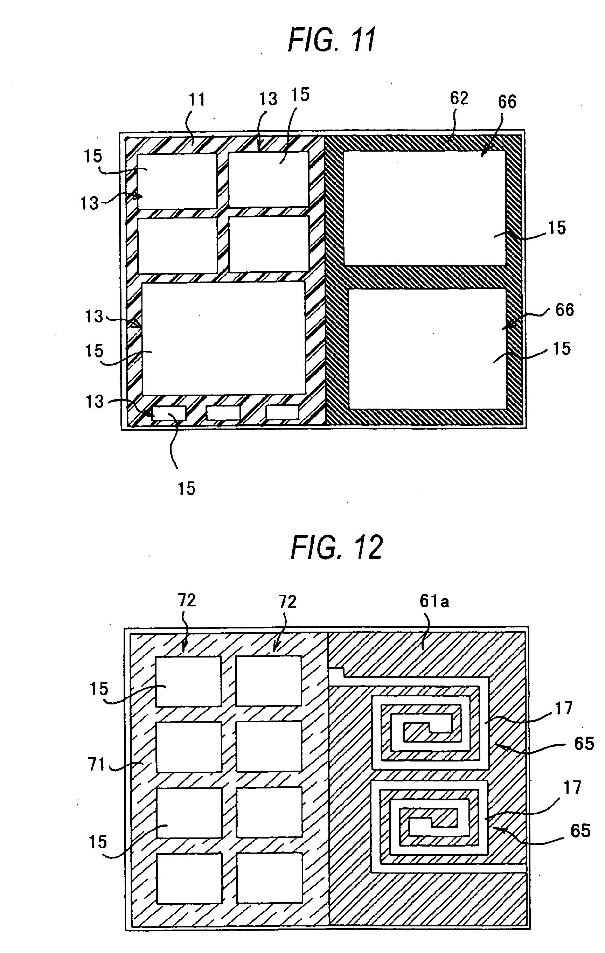

Figs. 11 to 13 show a multilayered substrate according to a fifth embodiment of the invention. As shown in Figs. 11 to 13, the multilayered substrate is provided with two layers on which different kinds of material films are disposed in the same manner as in the fourth embodiment. Referring to a first one (Fig. 11) of these layers, each functional material film is formed by a thin film method. Referring to a second layer (Fig. 12), each functional material film is formed by a thick film method.

As shown in Fig. 11, the first layer is provided with a high dielectric material thin film 11 and a semiconductor thin film 62, and an electric conductor 15 patterned rectangularly is provided on both surfaces of the thin films 11 and 62 to form a plurality of capacitors 13 having a high capacity and a plurality of varistors 66, respectively. On the other hand, the second layer is provided with a thick film formed by a resistor material, that is, a resistor material thick film 71 and a thick film formed by a magnetic material, that is, a magnetic thick film 61 a and the electric conductor 15 patterned rectangularly for a resistor and an electric conductor 17 patterned spirally for an impeder are provided on both surfaces of the thick films 71 and 61a to form a resistor 72 and an impeder 65 respectively as shown in Fig. 12.

For the formation of the thick films 71 and 61a, it is possible to utilize a transfer method using a PET film which has conventionally been known, for example. More specifically, a magnetic powder or a resistor powder is mixed into a resin material to prepare a composite material, and the composite material is applied onto the PET film subjected to a silicon treatment by a doctor blade method. Then, the film is stuck to a resin substrate and is thus heated and pressurized for a predetermined period of time, and the film is then peeled to carry out a transfer. In the transfer, it is possible to transfer and form the thick film in a desirable region by masking the resin substrate.

According to the multilayered substrate in accordance with the embodiment described above, a plurality of different functional material films is provided on the same layer surface in the substrate. Consequently, it is possible to provide desirable functional elements in the substrate at a high density. Moreover, it is possible to form functional materials having an excellent crystallinity and electrical characteristic, for example, a dielectric material, a magnetic material, a piezoelectric material, and a pyroelectric material on an organic substrate and the electrical characteristic which has conventionally been hard to implement in an organic substrate can be realized in the multilayered substrate. Furthermore, it is possible to form different kinds of material films in the same plane in combination with a thick film method capable of easily thinning a layer at a low cost. Consequently, it is possible to reduce the manufacturing cost of the multilayered substrate. Differently from the case in which the different kinds of material films are to be formed on the same layer in the ceramic burning substrate (Fig. 15), moreover, a crack 96 can be prevented from being generated in a boundary portion 94 between different kinds of material films 91 and 92 as shown in Fig. 14. For this reason, there is no possibility that the reliability of the substrate might be deteriorated.

In the invention, plural kinds of functional material films can be formed by an inorganic material. In this case, it is desirable that the thickness of the film should be set to be equal to or smaller than 5µm.

The reason is as follows. In an inorganic material film having a greater thickness than 5µm, there is easily caused a problem in that the flexibility of the film itself is remarkably deteriorated and the film is broken (cracked) in a process for manufacturing a substrate. In the case in which a dielectric layer is to be formed as the functional material film, moreover, it is desirable to set the thickness of the film to be 5µm or less in order to provide a capacitor having a high capacity. In this case, furthermore, the thickness of the film is preferably set to be equal to or greater than 0.1µm as the lower limit value of the thickness of the functional material film (dielectric layer). This is carried out in order to maintain the breakdown voltage property of the thin film.

Moreover, the plural kinds of functional material films may be thin films transferred onto the substrate after formation on a transferring substrate by a thin film method.

By utilizing the transfer method, thus, it is possible to once form a film on the transferring substrate which can withstand a heat treatment at a high temperature and to heat treat the film, thereby enhancing a crystallinity. For an organic resin substrate having no sufficient heat resistance, therefore, it is possible to provide a functional material film having an excellent electrical characteristic and to form a functional element by the film in the same manner.

In the invention, at least one of the plural kinds of functional material films is heat treated and has a crystallinity.

The temperature of the heat treatment is set to be 500°C to 900°C, for example. Consequently, it is possible to form a dielectric layer having a stable crystal structure and an excellent dielectric characteristic.

The plural kinds of functional material films are formed by a dielectric material, a magnetic material, a piezoelectric material, a pyroelectric material and a semiconductor material as described above, for example.

In the multilayered substrate according to the invention, moreover, the plural kinds of functional material films are formed by a composite material obtained by mixing and dispersing a functional powder into a resin.

For example, any of a dielectric material, a magnetic material, a piezoelectric material, a pyroelectric material and a semiconductor material is used for the functional powder.

Furthermore, the substrate provided with the plural kinds of functional material films mainly contains a resin. The "substrate mainly containing a resin" includes a substrate formed by a composite material obtained by mixing, into a resin, various inorganic materials (for example, a dielectric material, a magnetic material, a piezoelectric material, a pyroelectric material and a semiconductor material) in addition to a substrate constituted by only a resin material.

In the multilayered substrate according to the invention, furthermore, at least one substrate including the plural kinds of functional elements is laminated integrally with another substrate with a bonding material (including a prepreg and an adhesive sheet) interposed therebetween in some cases.

Moreover, the electronic component according to the invention mounts a surface mounting component on at least one of the surfaces of any of the multilayered substrates.

The invention is not restricted to the embodiments described with reference to the drawings but it is apparent to the skilled in the art that various changes can be made within a range described in claims.

### [Sixth Embodiment]

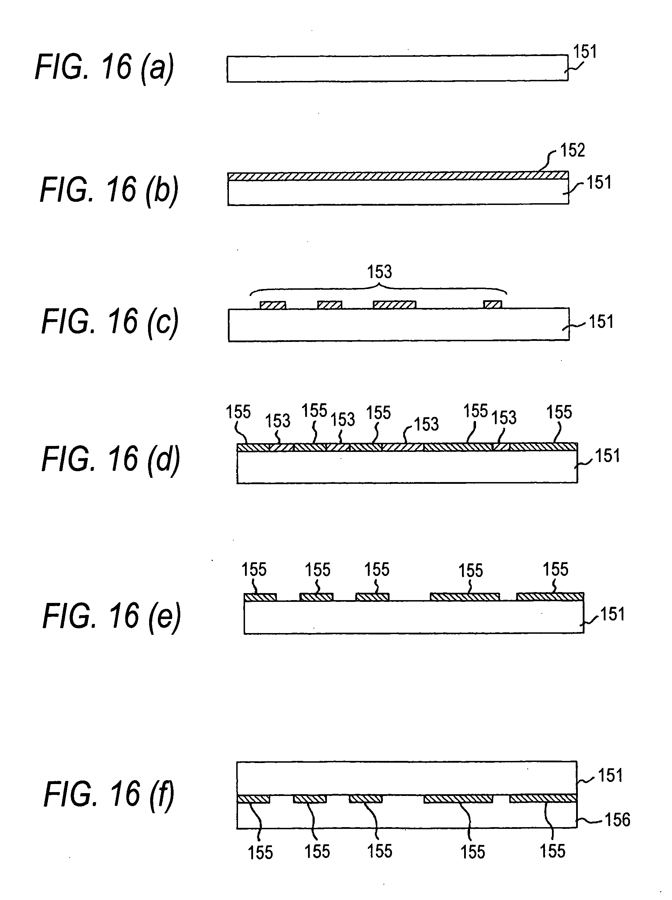

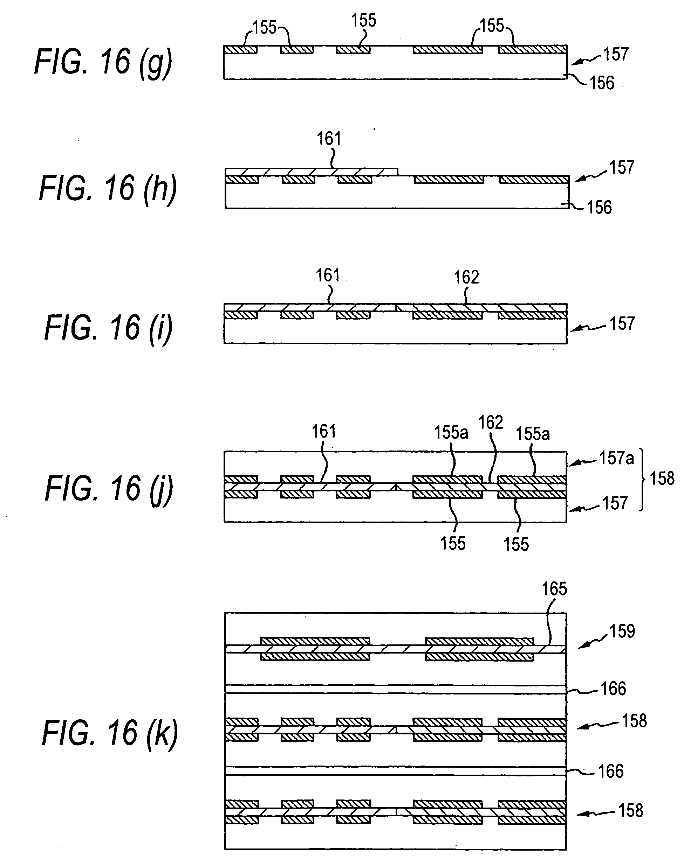

Figs. 16(a) to 16(k) show a method of manufacturing a multilayered substrate according to a second embodiment of the invention. In the embodiment shown in these drawings, different kinds of material films (a magnetic film and a dielectric film) are provided on the same layer in the multilayered substrate by using a thick film method, and consequently, different kinds of functional elements (an impeder and a capacitor) are formed in the same plane.
(1) First of all, a transferring substrate 151 is prepared (Fig. 16(a)), and a dry film 152 is stuck to the surface of the transferring substrate 51 (Fig. 16(b)), and the film 152 is subjected to patterning through photolithography by utilizing a mask in order to form a predetermined spiral pattern for an impeder and a rectangular pattern for a capacitor electrode, thereby forming a resist pattern 153 (Fig. 16(c)).
   As an example, an SUS304 tension anneal member having a surface passivated in a thickness of 0.1 mm is cut into a size of 100 mm long and 100 mm wide to prepare the transferring substrate 51, and the dry film 152 having a thickness of 29µm is stuck thereto and a spiral pattern (a line and space is set to be 30µm/30µm) for the impeder and a plurality of rectangular patterns (each of the rectangular patterns has a size of 4.5 mm long and 3.2 mm wide) for a capacitor electrode are formed over a whole region of 90 mm long and 90 mm wide of the film 152 so that the resist pattern 153 is formed.
(2) Next, glossing copper sulfate plating is carried out over the surface of the transferring substrate 151 provided with the resist pattern 153, for example, thereby forming a metallic conductor 155 (Fig. 16(d)). The composition of a plating solution in the copper sulfate plating can be set to have 200 g/l of copper sulfate pentahydrate and 100 g/l of sulfuric acid, for example.
(3) Subsequently, the resist 153 is removed (Fig. 16(e)). For example, by heating a 5% solution of sodium hydroxide to 50°C and carrying out spraying onto a surface at a side on which the pattern of the transferring substrate 151 is formed at a pressure of 1. 5 kg/cm², it is possible to remove the resist 153. After the removal of the resist, for example, the surface of an electric conductor is subjected to a darkening treatment with a mixed solution of sodium hypochlorite and sodium hydroxide and the substrate 151 is dried for 30 minutes at 100°C by means of a convection oven.
(4) Then, the transferring substrate 151 is inverted, and is vacuum pressed and transferred to a prepreg 156 (Fig. 16(f)), and thereafter, the transfer substrate 151 is peeled to fabricate a core substrate 157 on which an electric conductor is patterned (Fig. 16(g)). At least another core substrate 157 having the electric conductor patterned is fabricated to be used at a sticking step which will be described below (Fig. 16(j)). For the resin substrate (core substrate) 156 to be a transfer destination, it is possible to use the same various materials as those described in the first embodiment. As an example, a prepreg having a cloth in a thickness of 100µm can be used for the resin substrate 156.
(5) On the other hand, different kinds of materials are provided in the core substrate 157 having the electric conductor patterned. For this reason, a composite material in which various functional powders are mixed and dispersed into a resin material is prepared as a functional material. For example, in order to form a first functional film, a magnetic powder (for example, Fe-Ni-Zn type ceramics) is mixed into the resin material in an amount of 40% (a volumetric ratio) to generate a magnetic composite material, and the composite material is applied onto a PET film by a doctor blade method so as to have a thickness of 10µm. In order to form a second functional film, similarly, a dielectric powder (for example, Ba-Ti-Nd type ceramics) is mixed into the resin material in an amount of 40% (a volumetric ratio), for example, thereby generating a dielectric composite material, and the composite material is applied onto the PET film by the doctor blade method so as to have a thickness of 10µm, for example. It is desirable that the PET film should be previously subjected to a silicon treatment in order to enhance a peeling property at a next transferring step (Figs. 16(h) to 16(i)). For the resin material, it is desirable that a resin used in the core substrate should be mainly contained.
   As the dielectric powder for generating a dielectric composite material, it is possible to use various ceramics materials described in the first embodiment in addition to the Ba-Ti-Nd type ceramics. As the magnetic powder for generating a magnetic composite material, moreover, it is possible to use Mn-Zn type ferrite, Ni-Zn type ferrite, Ni-Zn type ferrite, Mn-Mg-Zn type ferrite, Ba type ferrite, Sr type ferrite, Ni-Cu-Zn type ferrite, iron oxide such as Fe₂O₃ or Fe₃O₄, Fe and various magnetic alloys containing Fe in addition to the Fe-Ni-Zn type ceramics.
(6) Then, the core substrate 157 having the electric conductor patterned is covered with a mask, and the PET film having the magnetic composite material applied thereto is stuck to the substrate 157 and they are heated and pressurized for a predetermined period of time, and thereafter, the PET film is peeled. Consequently, a magnetic film 161 can be transferred as a first functional film to a first region in which the magnetic layer on the surface of the core substrate is to be formed (Fig. 16(h)).
(7) Furthermore, the core substrate 157 having the electric conductor patterned is covered with another mask, and the PET film having the dielectric composite material applied thereto is stuck to the substrate 157 and they are heated and pressurized for a predetermined period of time, and thereafter, the PET film is peeled. Consequently, a dielectric film 162 can be transferred as a second functional film to a second region in which the dielectric layer on the surface of the core substrate is to be formed (Fig. 16(i)).
   The order of the transfer of the magnetic film 161 and the dielectric film 162 may be reversed. Referring to the material of the functional film to be formed on the core substrate, it is also possible to use a piezoelectric material (for example, a composite material obtained by mixing and dispersing PbTiO₃-PbZrO₃) into a resin material, a pyroelectric material (for example, a composite material obtained by mixing and dispersing PbTiO₃ into a resin material), a semiconductor material (for example, a composite material obtained by mixing and dispersing BaTiO₃ into a resin material) and other materials in addition to the dielectric material and the magnetic material described above, and various functional films can be formed by these materials. Furthermore, it is also possible to form three kinds of materials (functional films) or more in different regions in the same plane.
(8) The magnetic film 161 and the dielectric film 162 are transferred to the core substrate 157, and the same substrate 157a having an electric conductor as the substrate 157 which is formed separately is then superposed and heat pressed so that both of the substrates 157 and 157a are stuck to each other (Fig. 16(j)). At this time, the magnetic film 161 and the dielectric film 162 fulfill the function of a prepreg and both of the substrates 157 and 157a are bonded thereto. When these substrates 157 and 157a are to be superposed on each other, moreover, the magnetic film 161 and the dielectric film 162 are interposed between the electric conductor forming surfaces of both of the substrates 157 and 157a, and furthermore, an alignment is thus carried out in such a manner that the counter electrode of a capacitor can be formed by the metallic conductors 155 and 155a provided in a portion in which the dielectric film 162 is formed.
(9) Furthermore, a plurality of substrates 158 thus stuck is fabricated, and is superposed and pressed with a prepreg 166 (or an adhesive sheet) interposed therebetween so that a multilayered substrate is formed (Fig. 16(k)). At this time, the substrate to be laminated is not restricted to the substrate 158 according to the embodiment which has different kinds (plural kinds) of functional films but may contain a substrate 159 having a single kind of functional film 165, and it is possible to constitute various multilayered structures by properly combining an optional number of substrates. For the method of forming a functional film, moreover, the thick film method has been used in the second embodiment and the thin film method has been used in the first embodiment, and it is also possible to form a film in combination of the thick film method and the thin film method. For example, the first functional film to be formed on the same plane can be provided by the thin film method and the second functional film can be formed by the thick film method. In this case, it is preferable to provide the prepreg or the adhesive sheet in the thin film portion in order to maintain an adhesive property between the substrates.

According to the method of manufacturing a multilayered substrate in accordance with the embodiment, a plurality of different functional material films can be provided on the same plane in the substrate and a desirable functional element having an excellent electrical characteristic can be included in the substrate at a high density. Moreover, an inorganic thin film material to be originally subjected to a film forming treatment at a high temperature (500 to 900°C) can be provided without a complicated step in the same structure as an organic material having a low heat resistance. Furthermore, each layer has been subjected to a thermal press treatment in a conventional method using a metallic foil having a resin. According to the embodiment, however, it is possible to collectively press substrate components (Figs. 16(j) and 16(k)). Consequently, it is possible to manufacture a laminated substrate at a low cost in a small number of steps.

As described above, the manufacturing method according to the invention includes a step of providing the plural kinds of functional films on a transferring substrate by a thin film method and a step of transferring the plural kinds of functional films to a core substrate.

By utilizing the transfer method, thus, it is possible to once form a film on the transferring substrate having a high heat resistance and to transfer the film to the core substrate. For an organic resin substrate having no sufficient heat resistance, consequently, it is possible to form a functional film having an excellent electrical characteristic and a functional element by the film.

It is possible to dispose plural kinds of functional films on the transferring substrate by repeating a step of carrying out masking over the transferring substrate to provide the functional film on the transferring substrate for each of the plural kinds of functional films. In the invention, it is also possible to provide the plural kinds of functional films on the transferring substrate at the same time.

Moreover, the transferring step includes a step of pressing the surface of the transferring substrate on which the functional film is provided against a prepreg while heating and pressurizing the same surface, thereby curing the prepreg, and a step of peeling the transferring substrate.

Furthermore, there is/are provided a step of providing a metal film prior to the step of providing the plural kinds of functional films or/and a step of providing a metal film after the step of providing the plural kinds of functional films.

In the invention, moreover, the plural kinds of functional films are formed by a composite material obtained by mixing and dispersing various functional powders into a resin material, and are provided on a support film and are then transferred to a core substrate.

In this case, a metal film may be provided on the core substrate.

In the case in which the functional film is provided on the core substrate, moreover, the step of carrying out masking over the core substrate to provide a functional film on the core substrate is repeated for each of the plural kinds of functional films. In the invention, it is also possible to dispose plural kinds of functional films on the core substrate at the same time.

The functional film may be any of a dielectric film, a magnetic film, a piezoelectric film, a pyroelectric film and a semiconductor film.

Furthermore, the method of manufacturing a multilayered substrate according to the invention comprises a step of laminating at least one core substrate including the plural kinds of functional films integrally with another core substrate with a bonding material (including a prepreg) interposed therebetween.

In addition, the method of manufacturing an electronic component according to the invention further comprises each step in any of the methods of manufacturing a multilayered substrate and a step of mounting a surface mounting component on at least one of the surfaces of the multilayered substrate.

The invention is not restricted to the embodiment described with reference to the drawings but it is apparent to the skilled in the art that various changes can be made within a range described in claims.

### [Seventh Embodiment]

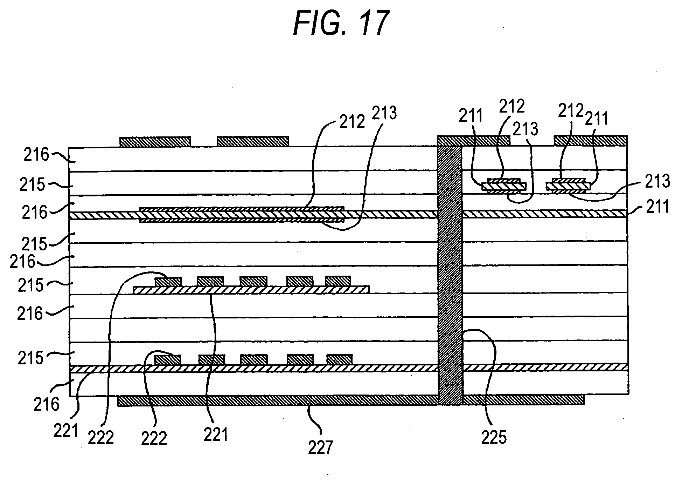

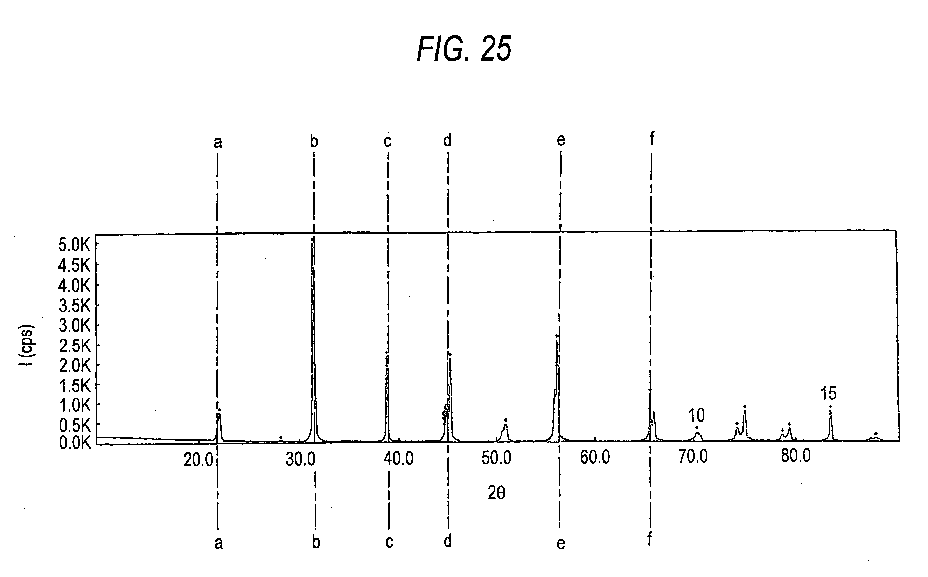

An embodiment of the invention (which will be hereinafter referred to as the embodiment) will be described below with reference to Figs. 17 to 25 of the accompanying drawings.

As shown in Fig. 17, a multilayered substrate according to the embodiment comprises a dielectric ceramic thin film 211 formed by a thin film method therein, and electrode films 212 and 213 are provided on both surfaces of the dielectric thin film 211 to form a capacitor which is held by substrate materials (organic insulating materials) 215 and 216 mainly containing a resin.

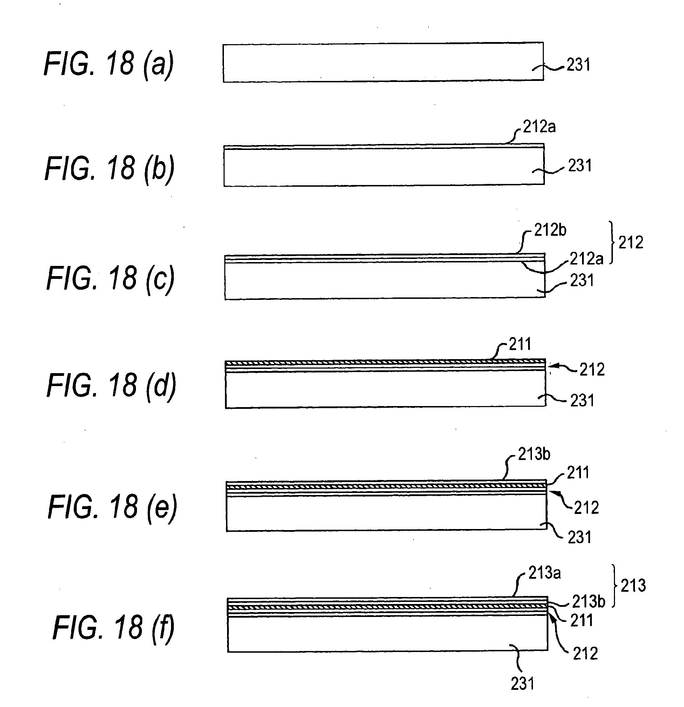

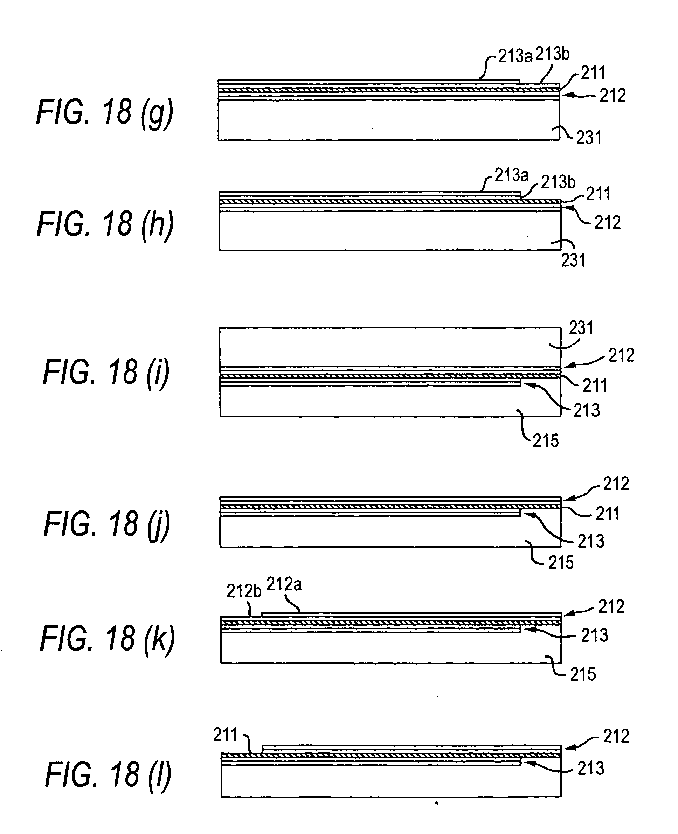

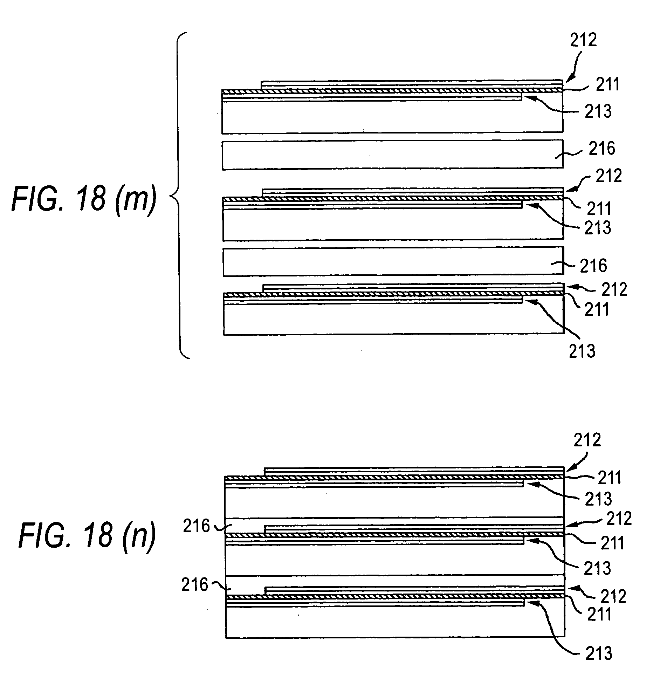

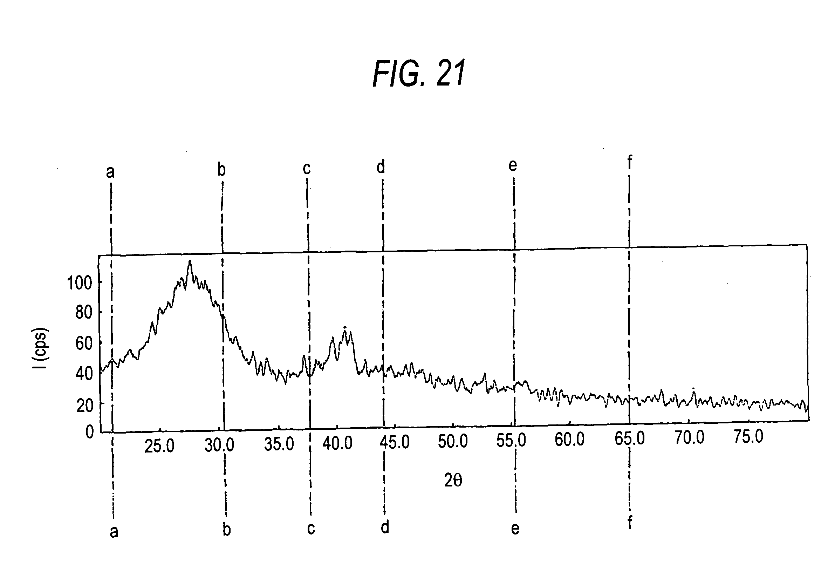

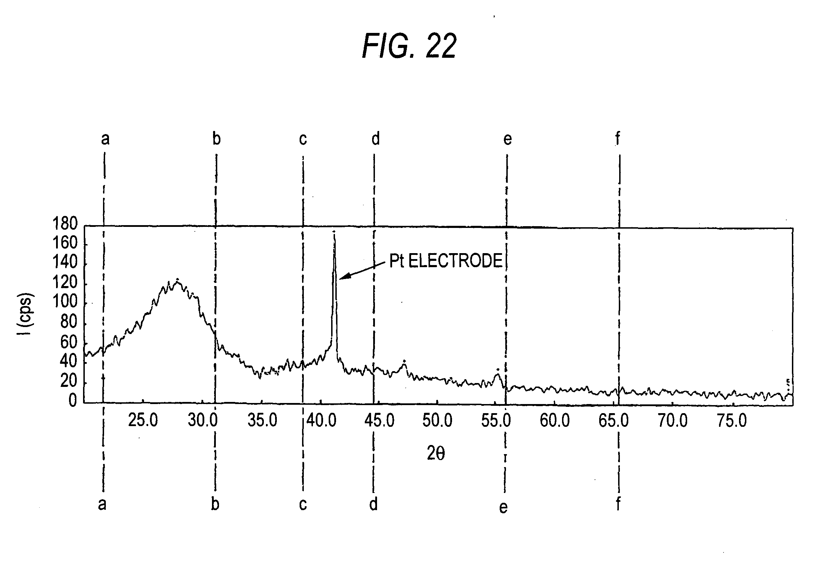

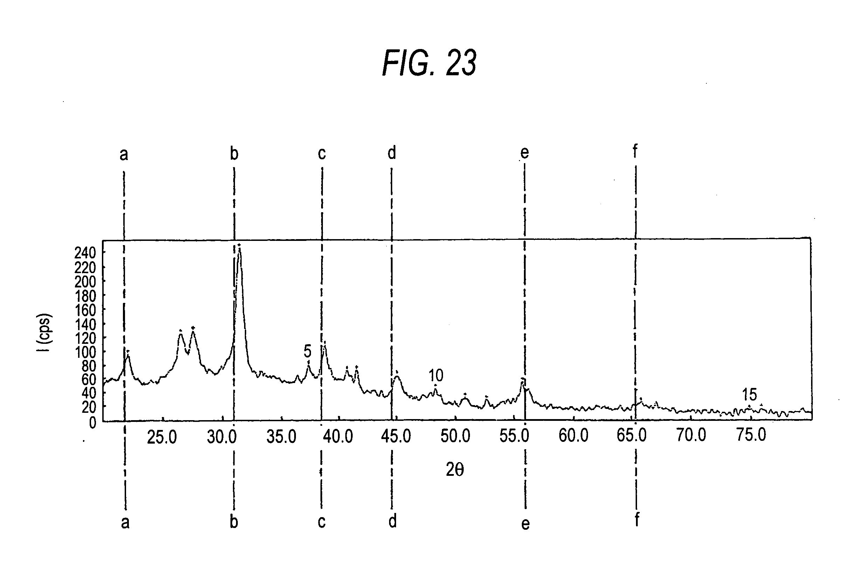

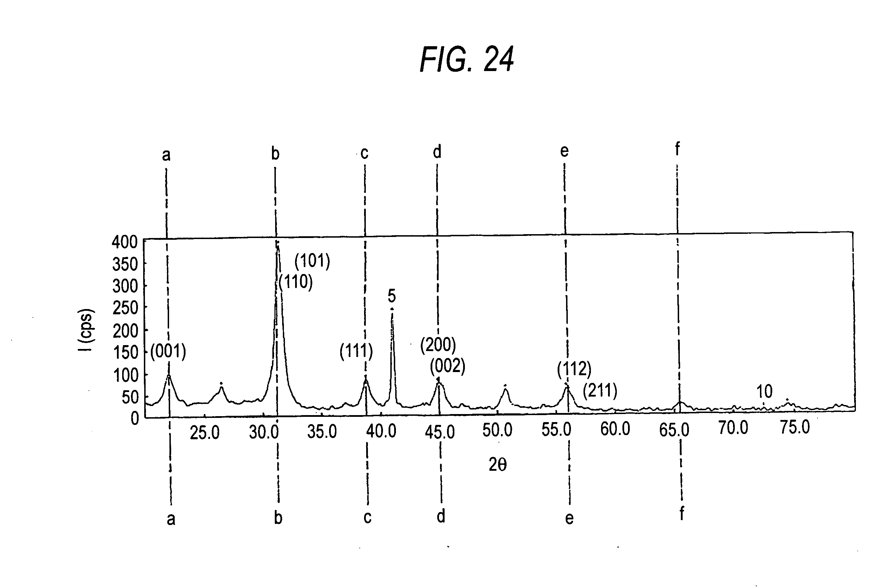

In order to form the dielectric ceramic layer 211 in the multilayered substrate, specifically, a dielectric thin film is formed on a transferring substrate having a heat resistance and is heat treated to enhance a crystallinity thereof, and is then transferred to a resin substrate. This process will be described in more detail with reference to Figs. 18(a) to 18(n).
(1) First of all, a transferring substrate 31 is prepared (Fig. 18(a)) and a metal film 212 to be an electrode is formed on the surface of the transferring substrate 231 by a thin film method such as sputtering (Figs. 18(b) and 18(c)). At this time, it is possible to use, as the transferring substrate 231, a substrate formed by an inorganic substrate having a heat resistance of 500°C or more. For example, it is possible to use a substrate such as silicon, SUS (stainless), alumina, zirconia, quartz, sapphire, magnesium oxide or zirconium oxide.
For a metallic electrode film, it is possible to use an electric conductor material having a conductivity, for example, copper (Cu), titanium (Ti), nickel (Ni), gold (Au), silver (Ag), platinum (Pt), palladium (Pd), tungsten (W), molybdenum (Mo) and an ally containing at least one of them, and any type can be used. As a preferable manner, in the embodiment, the electrode film to be formed is set to have a two-layer structure, and a Pt film 212a having an excellent heat resistance and reducing resistance in a heat treatment is first formed on the surface of the transferring substrate 231 and a Ti film 212b having a high adhesion to a dielectric ceramic layer is formed thereon.
As a method of forming an electrode film, it is possible to use evaporation, CVD, laser abrasion, the burning of a sol/gel forming film, plating and other methods in addition to the sputtering. In order to enhance the reliability of a substrate/module, it is desirable to use a dry method such as sputtering, evaporation or CVD which can form a smoother metal film. According to these dry film forming methods, concavo-convex portions can be prevented from being generated differently from an electrolytic metallic foil. Therefore, it is possible to prevent the generation of a local electric field concentration when the electrode film is used as the counter electrode of a capacitor.
(2) Next, the dielectric ceramic layer 211 is formed on the electrode film 212 by a thin film method such as sputtering, evaporation, CVD, laser abrasion or the burning of a sol/gel forming film (Fig. 18(d)). As a material for forming the dielectric ceramic layer 211, for example, it is possible to use barium titanate type ceramics. In addition, it is possible to form the dielectric ceramic layer 211 by titanium - barium - neodymium type ceramics, titanium - barium - tin type ceramics, lead - calcium type ceramics, titanium dioxide ceramics, lead titanate type ceramics, strontium titanate type ceramics, calcium titanate type ceramics, bismuth titanate type ceramics, magnesium titanate type ceramics, CaWO₄ type ceramics, Ba (Mg, Nb) O₃ type ceramics, Ba (Mg, Ta) O₃ type ceramics, Ba (Co, Mg, Nb) O₃ type ceramics or Ba (Co, Mg, Ta) O₃ type ceramics.
It is preferable that the thickness of the dielectric ceramic layer 211 should be set to be equal to or greater than 0.1µm in order to maintain a breakdown voltage property and should be set to be equal to or smaller than 5µm in order to form a capacitor having a high capacity. In a ceramic dielectric film having a greater thickness than 5µm, moreover, there is easily caused a problem in that the flexibility of the film itself is remarkably eliminated and the film itself is cracked in a manufacturing process at time of the transfer of a substrate, which is not preferable.
(3) After the formation of the dielectric ceramic layer 211, the layer 211 is heat treated to enhance a crystallinity. It is preferable that the temperature of the heat treatment should be set to be 500°C to 900°C. Consequently, it is possible to form a dielectric ceramic layer having a stable crystal structure and an excellent dielectric characteristic. Referring to a crystalline form, it is desirable that a crystallinity should be enhanced in order to obtain a more excellent dielectric characteristic and the separation of a perovskite peak should be clearly seen as shown in Figs. 23 and 24.
The following Table 1 shows a dielectric constant in the case in which a barium titanate thin film formed by sputtering is not heat treated and the case in which the heat treatment is carried out at various temperatures, and Figs. 21 to 25 are X-ray diffraction charts thereof As is apparent from the Table and the drawings, a barium titanate compound having a very poor crystallinity shown in Fig. 21 (no heat treatment) or Fig. 22 (heat treatment at 300°C) has a crystallinity enhanced as shown in Figs. 23 and 24 by the heat treatment and exhibits a clear perovskite structure. With the enhancement in the crystallinity by the heat treatment, a dielectric constant ε of the barium titanate film is enhanced all at once from 20 to 30 in the formation of the thin film to 200 or more in the case in which the crystallinity is enhanced by a heat treatment at 500°C or more.

**[Table 1]**

| Dielectric Characteristic of BaTiO₃ Thin Film Formed by Sputtering | | | |
|---|---|---|---|
| No. | Heat treatment temperature | Dielectric constant (100 KHz) | XRD |
| 1 | None (immediately after sputtering) | 27.8 | Fig. 21 |
| 2 | 300°C | 32.8 | Fig. 22 |
| 3 | 400°C | 38.2 | |
| 4 | 500°C | 298.0 | Fig. 23 |
| 5 | 700°C | 334.5 | Fig. 24 |
| 6 | 800°C | 375.5 | |
| 7 | 900°C | 394.1 | |
| 8 | 1000°C | Unmeasured (Because peeling from a substrate electrode dielectric is caused by influence due to a difference in a thermal expansion) | |
| Sintered product | 1300°C (burning) | | Fig. 25 |

(4) After the heat treatment, the electrode film 213 is formed on the dielectric ceramic layer 211 (Figs. 18(e) and Fig. 18(f)). The electrode film 213 has a two-layer structure in the same manner as the electrode film 212 formed in Figs. 18(b) and 18(c), and a Ti film 213b is first formed on the dielectric ceramic layer 211 and a Cu film 213a is formed thereon. Cu has such an advantage that an electrical resistance is lower at a smaller cost than the Pt electrode film provided earlier. However, the electrode film formed directly on the transferring substrate is subjected to a heat treating step. For this reason, the Pt film which is excellent in a heat resistance and an oxidation resistance is more suitable. Therefore, it is desirable to use different materials for electrode films to be formed on both sides with a dielectric interposed therebetween. As another example of the combination, it is desirable that the electrode film 212a to be formed directly on the transferring substrate should be formed by an electrode material having a high melting point and the electrode film 213a should be selected from the combination of inexpensive electrode materials having low electrical resistances as in Ni - Ti / Ag - Ti (the Ni electrode film 212a and the Ti electrode film 212b for the electrode film 212 / the Ag electrode film 213a and the Ti electrode film 213b for the electrode film 213).
(5) After the formation of the electrode film 213, the electrode films 213a and 213b are patterned by etching (Figs. 18(g) and 18(h)). Both wet etching and dry etching can be applied to the patterning for the electrode film.
(6) After the patterning, the transferring substrate 231 is inverted and a press treatment is carried out over the resin prepreg (an organic material in a B stage state) 215 while performing pressurization and heating, and a transfer is thus executed (Fig. 18(i)). Then, the transferring substrate 231 is peeled (Fig. 18(j)). In the transfer, it is also possible to transfer the dielectric ceramic layer 211 having the electrode films 212 and 213 onto a resin substrate set in a curing state by pressing the resin substrate through an adhesive layer without using the prepreg 215.
It is preferable that the organic resin substrate 215 to be transferred should have an excellent dielectric characteristic and a low water absorbing property, and both of a thermoplastic resin and a thermosetting resin can be utilized. More specifically, it is possible to use an epoxy resin, a phenol resin, a vinylbenzyl ether compound, bismaleimide triazine, a polyolefin type resin, polyimide, polyester, polyphenylene oxide, polyphenylene sulfide, a liquid crystal polymer, a fluorine type resin and a resin containing at least one of them, for example. Moreover, it is also possible to mix a dielectric ceramic powder or a magnetic powder into these resins if necessary, thereby giving various electrical characteristics to the substrate itself.
By regulating a pressure in the transfer to be 1 to 3 MPa, moreover, it is easy to bury a capacitor element layer formed to be a thin film in a prepreg simultaneously with the transfer. When the capacitor element is buried in the prepreg, a step is not generated in the lamination of a substrate to be carried out at a subsequent step. Consequently, a void in the outer peripheral portion of the capacitor is gone. Therefore, it is possible to enhance a reliability for the moisture resistance of the capacitor element formed in a multilayered substrate.
(7) After the peeling of the transferring substrate, the electrode film 212 formed first and covering the surface of the dielectric ceramic layer 211 is aligned with the electrode film 213 having the pattern formed thereon and patterning is carried out in such a manner that a counter electrode can be formed (Figs. 18(k) and 18(1)). Consequently, it is possible to form, on an organic substrate, a capacitor having a large capacity which could not be provided on a substrate using a resin or a composite material having a dielectric ceramic material dispersed into an organic substrate or a resin substrate in the conventional art.
(8) Then, a plurality of organic resin substrates including the capacitor (dielectric ceramic layer) thus formed is laminated by pressing (Fig. 18(n)) with the resin prepreg 216 interposed therebetween (Fig. 18(m)). Consequently, it is possible to form a multilayered substrate including a plurality of capacitor element layers having a high capacity.

At the laminating step, it is possible to laminate a thin film magnetic material layer, a resistor layer and various functional layers including a coil pattern as well as the dielectric ceramic layer (capacitor layer). The multilayered substrate according to the embodiment shown in Fig. 17 further includes an inductor 222 having a predetermined coil pattern formed adjacently to a thin film magnetic material layer 221 in addition to the capacitor. Moreover, it is possible to mount various chip components on the surface of the multilayered substrate thus formed. In Fig. 17, the reference numerals 225 and 227 denote a through hole and a ground electrode, respectively.

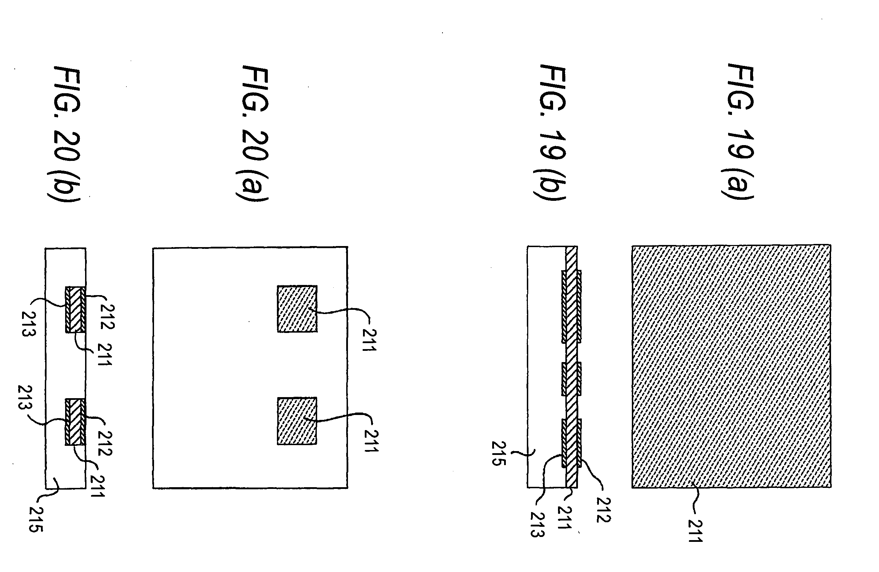

While the dielectric ceramic layer 211 can also be formed on the whole substrate as shown in Figs. 18(a) to 18(n) and Figs. 19(a) and 19(b), furthermore, the dielectric ceramic layer 211 can also be formed in a part of the substrate as shown in Figs. 20(a) and 20(b). In order to form the dielectric ceramic layer on a part of the substrate, thus, it is preferable to carry out masking over the transferring substrate and to form, on the transferring substrate, the dielectric ceramic layer 211 including the electrode films 212 and 213 on both surfaces and to then transfer them to the resin substrate 215. It is also possible to form other functional layers such as a magnetic layer and a resistor layer in portions other than the portion in which the dielectric ceramic layer 211 is formed.

### [Example]

An example of the invention will be described below.

A silicon wafer substrate having a thickness of 0.4 mm was prepared as the transferring substrate 231. Films were formed on the silicon wafer substrate in order ofPt and Ti in a thickness of 0.1µm by sputtering, and the electrode film 212 was formed. Next, a thin film of barium titanate was formed in a thickness of 0.3µm on the electrode film 212 by RF sputtering on a heating condition of 600°C and was set to be the dielectric ceramic layer 211. Furthermore, films were formed in order of Ti and Cu in a thickness of 0.1µm on the dielectric ceramic layer 211.

Subsequently, the electrode film 213 provided on a surface was etched in such a manner that a capacitor can be formed, and a predetermined pattern was thus formed. This is pressurized, heated and pressed against a vinylbenzyl resin prepreg having a thickness of 100µm with the transferring substrate inverted. Then, the transferring substrate was peeled. In this state, the metallic electrode film 212 covers a whole surface. The metallic electrode film 212 was aligned with a pattern etched to form the capacitor and patterning was carried out in such a manner that a counter electrode can be formed.

Consequently, a capacitor having a large capacity which could not be formed by an organic substrate in the conventional art could be formed on an organic substrate.

Next, a Cu film was formed on a silicon wafer substrate having a thickness of 0.4 mm in the same manner and a Ti film was then formed, and the Cu and Ti films were then etched and patterned like a coil. Furthermore, a film of SiO₂ was formed in a thickness of 0.2µm by sputtering in order to maintain an insulating property, and an Ni-Fe film was formed in a thickness of 0.3µm thereon and the magnetic layer 221 was thus formed. This was transferred to a vinyl benzyl resin prepreg in the same manner as the dielectric ceramic layer 211 and a substrate including the magnetic film 221 and having the coil 222 was created. A temperature in the transfer was set to be approximately 200°C and a pressure to be applied in the transfer was set to be approximately 2 MPa. Then, the substrate and the dielectric film were laminated with the resin prepreg 216 interposed therebetween so that the laminated product shown in Fig. 17 could be formed.

As described above, in the invention, it is preferable that a temperature for the heat treatment of the dielectric ceramic layer should be set to be 500°C to 900°C, and there is easily caused a problem in that the flexibility of a ceramic dielectric film having a greater thickness than 5µm itself is remarkably eliminated and the film itself is cracked in the manufacturing process at time of the transfer of the substrate. For this reason, it is preferable that the thickness of the dielectric ceramic layer should be set to be equal to or smaller than 5µm.

Furthermore, at least one (one or more) capacitor element layer constituted by a dielectric ceramic layer and an electrode film in the same plane is buried and formed in a substrate mainly containing a resin.

Moreover, a pair of electrode films provided with the dielectric ceramic layer interposed therebetween are formed by different materials on opposite sides, respectively.

The method of manufacturing a multilayered substrate according to the invention in which a multilayered substrate having at least one layer (one or more) capacitor element layer is provided in the substrate, comprises the steps of forming a first electrode film on a transferring substrate, forming a dielectric ceramic layer on the first electrode film by a thin film method, heat treating the dielectric ceramic layer to enhance a crystallinity, forming a second electrode film on the surface of the dielectric ceramic layer after the heat treating step, and transferring the dielectric ceramic layer including the first and second electrode films onto a resin prepreg.

The transferring step includes a step of burying a capacitor element layer in the prepreg simultaneously with the transfer.

Moreover, the manufacturing method further comprises the steps of patterning the second electrode film after the step of forming the second electrode film, transferring, onto a resin prepreg, the dielectric ceramic layer including the second electrode film thus patterned and the first electrode film, and patterning the first electrode film after the transferring step.

In addition, the manufacturing method further comprises the steps of masking a transferring substrate into an electrode pattern and forming a first electrode pattern on the transferring substrate by a thin film method, forming a dielectric ceramic layer by the thin film method, heat treating the dielectric ceramic layer to enhance a crystallinity, masking the dielectric ceramic layer into an electrode pattern to form a second electrode pattern by the thin film method after the heat treating step, and transferring, onto a resin prepreg, the dielectric ceramic layer including the first and second electrode patterns.

In the manufacturing method, moreover, a temperature in the heat treatment of the dielectric ceramic layer is set to be 500°C to 900°C.

### Industrial Applicability

As described above, according to the invention, it is possible to obtain an organic multilayered substrate including, at a high density, a functional element which is excellent in an electrical characteristic and having a high reliability.

By transferring, onto an organic resin substrate, a dielectric ceramic layer having a crystallinity enhanced by a heat treatment, moreover, it is possible to form a ceramic layer having a high dielectric constant in the substrate. Therefore, it is possible to provide an organic multilayered resin substrate including a capacitor having a small size, a high function and a high reliability.

## Claims

1. A multilayered substrate obtained by laminating a plurality of substrates and including plural kinds of functional elements therein,
wherein at least one of the substrates has, on the same plane, a first functional material film and a second functional material film formed by a second functional material which is different from the first functional material film, and the plural kinds of functional elements are formed by the first and second functional material films.

2. The multilayered substrate according to claim 1, wherein the first and second functional material films are thin films having a thickness of 5µm or less which is formed by an inorganic material.

3. The multilayered substrate according to claim 1, wherein the first and second functional material films are thin films which are formed on a transferring substrate by a thin film method and are then transferred to the substrate.

4. The multilayered substrate according to claim 1, wherein at least one of the first and second functional material films is heat treated to enhance a crystallinity.

5. The multilayered substrate according to any of claims 1 to 4, wherein the first and second functional material films are formed by any of a dielectric material, a magnetic material, a piezoelectric material, a pyroelectric material and a semiconductor material.

6. The multilayered substrate according to claim 1, wherein at least one of the first and second functional material films is formed by a composite material obtained by mixing and dispersing a functional powder into a resin.

7. The multilayered substrate according to claim 6, wherein the functional powder is any of a dielectric material, a magnetic material, a piezoelectric material, a pyroelectric material and a semiconductor material.

8. The multilayered substrate according to claim 1, wherein the substrate provided with the plural kinds of functional material films mainly contains a resin.

9. The multilayered substrate according to claim 1, wherein at least one substrate including the plural kinds of functional elements is laminated integrally with another substrate with a bonding material interposed therebetween.

10. An electronic component mounting a surface mounting component on at least one of surfaces of the multilayered substrate according to any of claims 1 to 9.

11. A method of manufacturing a multilayered substrate including plural kinds of functional elements therein, comprising the step of:
providing a first functional film and a second functional film which is different from the first functional film in the same plane of a core substrate.

12. The method of manufacturing a multilayered substrate according to claim 11, further comprising the steps of:
providing the first and second functional films on a transferring substrate by a thin film method; and
transferring the first and second functional films to the core substrate.

13. The method of manufacturing a multilayered substrate according to claim 12, wherein the transferring step further includes the steps of:
pressing a surface of the transferring substrate on which the functional film is provided against a prepreg with heating and pressurization, thereby curing the prepreg; and
peeling the transferring substrate.

14. The method of manufacturing a multilayered substrate according to claim 12, further comprising both or either a step of providing a metal film prior to the step of providing the first and second functional films, and/or a step of providing a metallic film after the step of providing the first and second functional films.

15. The method of manufacturing a multilayered substrate according to claim 12, wherein the step of providing the functional films on a transferring substrate repeats a step of masking the transferring substrate to provide the functional films on the transferring substrate for each of the first and second functional films.

16. The method of manufacturing a multilayered substrate according to claim 11, wherein at least one of the first and second functional films is formed by a composite material obtained by mixing and dispersing various functional powders into a resin material, the method further comprising a step of providing the functional film on a support film and a step of transferring the functional film to a core substrate.

17. The method of manufacturing a multilayered substrate according to claim 16, further comprising a step of providing a metal film on the core substrate.

18. The method of manufacturing a multilayered substrate according to claim 16, wherein the step of providing the functional film on a core substrate repeats a step of masking the core substrate to provide the functional film on the core substrate for each of the plural kinds of functional films.

19. The method of manufacturing a multilayered substrate according to claim 1, wherein the functional film is any of a dielectric film, a magnetic film, a piezoelectric film, a pyroelectric film and a semiconductor film.

20. The method of manufacturing a multilayered substrate according to claim 1, further comprising a step of laminating at least one core substrate including the first and second functional films integrally with another core substrate with a bonding material interposed therebetween.

21. A method of manufacturing an electronic component, further comprising each of the steps in the method of manufacturing a multilayered substrate according to any of claims 1 to 10, and a step of mounting a surface mounting component on at least one of surfaces of the multilayered substrate.

22. A multilayered substrate including at least one capacitor element layer therein, wherein the capacitor element layer is formed by a dielectric ceramic layer provided by a thin film method and having a crystallinity enhanced by a heat treatment and an electrode film provided on both surfaces of the dielectric ceramic layer, and is held by a substrate mainly containing a resin.

23. The multilayered substrate according to claim 22, wherein a temperature for the heat treatment of the dielectric ceramic layer is 500°C to 900°C, and the dielectric ceramic layer has a thickness of 5µm or less.

24. The multilayered substrate according to claim 22, wherein at least one capacitor element layer formed by the dielectric ceramic layer and the electrode film in the same plane is buried and formed in a substrate mainly containing a resin.

25. The multilayered substrate according to claim 22, wherein a pair of electrode films formed with the dielectric ceramic layer interposed therebetween are formed by different materials on opposite sides, respectively.

26. A method of manufacturing a multilayered substrate in which a multilayered substrate including at least one capacitor element layer is formed, comprising the steps of forming a first electrode film on a transferring substrate, forming a dielectric ceramic layer on the first electrode film by a thin film method, heat treating the dielectric ceramic layer to enhance a crystallinity, forming a second electrode film on a surface of the dielectric ceramic layer after the heat treating step, and transferring the dielectric ceramic layer including the first and second electrode films onto a resin prepreg.

27. The method of manufacturing a multilayered substrate according to claim 26, wherein the transferring step includes a step of burying the capacitor element layer in the prepreg simultaneously with the transfer.

28. The method of manufacturing a multilayered substrate according to claim 26, further comprising the steps of patterning the second electrode film after the step of forming the second electrode film, transferring a dielectric ceramic layer including the second electrode film thus patterned and the first electrode film onto a resin prepreg, and patterning the first electrode film after the transferring step.

29. The method of manufacturing a multilayered substrate according to claim 26, further comprising the steps of masking a transferring substrate into an electrode pattern to form a first electrode pattern on the transferring substrate by a thin film method, forming a dielectric ceramic layer by the thin film method, heat treating the dielectric ceramic layer to enhance a crystallinity, masking the dielectric ceramic layer into an electrode pattern to form a second electrode pattern by the thin film method after the heat treating step, and transferring the dielectric ceramic layer including the first and second electrode patterns onto a resin prepreg.

30. The method of manufacturing a multilayered substrate according to claim 26, wherein a temperature for the heat treatment of the dielectric ceramic layer is 500°C to 900°C.
